(19) Europäisches Patentamt / European Patent Office / Office européen des brevets

(11) **EP 2 818 828 B1**

(12) **EUROPEAN PATENT SPECIFICATION**

(45) Date of publication and mention
of the grant of the patent:
**16.11.2016 Bulletin 2016/46**

(51) Int Cl.:
***G01C 17/38*** *(2006.01)*     ***G01R 33/02*** *(2006.01)*
***G01R 33/00*** *(2006.01)*

(21) Application number: **13752179.5**

(22) Date of filing: **22.02.2013**

(86) International application number:
**PCT/JP2013/001021**

(87) International publication number:
**WO 2013/125242 (29.08.2013 Gazette 2013/35)**

(54) **OFFSET ESTIMATION DEVICE, OFFSET ESTIMATION METHOD, OFFSET ESTIMATION PROGRAM AND INFORMATION PROCESSING DEVICE**

VERSATZSCHÄTZUNGSVORRICHTUNG, VERSATZSCHÄTZUNGSVERFAHREN, VERSATZSCHÄTZUNGSPROGRAMM UND INFORMATIONSVERARBEITUNGSVORRICHTUNG

DISPOSITIF D'ESTIMATION DE DÉCALAGE, PROCÉDÉ D'ESTIMATION DE DÉCALAGE, PROGRAMME D'ESTIMATION DE DÉCALAGE ET DISPOSITIF DE TRAITEMENT D'INFORMATIONS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.02.2012 JP 2012038471**

(43) Date of publication of application:
**31.12.2014 Bulletin 2015/01**

(73) Proprietor: **Asahi Kasei Kabushiki Kaisha
Kita-ku, Osaka-shi
Osaka 530-8205 (JP)**

(72) Inventors:
• **KONDA, Masahiro
Chiyoda-ku, Tokyo 101-8101 (JP)**

• **YAMASHITA, Masaya
Chiyoda-ku, Tokyo 101-8101 (JP)**

(74) Representative: **Hoffmann Eitle
Patent- und Rechtsanwälte PartmbB
Arabellastraße 30
81925 München (DE)**

(56) References cited:
**WO-A1-2005/061990     WO-A1-2010/058594
WO-A1-2011/037118     JP-A- H0 534 157
JP-A- S63 128 222     JP-A- 2005 265 414
JP-A- 2011 022 025     JP-A- 2011 185 863**

**Description**

Technical Field

The present invention relates to a technology for estimating an offset of magnetic data to be outputted from a magnetic sensor in use for measuring an azimuth.

Background Art

An azimuth measurement device for measuring an azimuth with use of a geomagnetic field has been known. In general, the azimuth measurement device detects a magnetic field to be generated by a magnet or so forth as well as a geomagnetic field, simultaneously. Therefore, when measured, an azimuth is obtained by subtracting a signal component attributed to the magnetic field (i.e., offset) from the detected geomagnetic field. For example, an azimuth measurement device described in PTL 1 is configured to measure an azimuth with use of a geomagnetic field detected by a tri-axis magnetic sensor and the offset.

Citation List

Patent Literature

PTL 1: Japan Patent Laid-open No. 2004-309227

Summary of Invention

Technical Problem

As disclosed in PTL 1, there has conventionally existed a device for measuring an azimuth with use of a geomagnetic field and an offset. However, the offset has been estimated only with geomagnetic data measured by performing movement, rotation and so forth of the azimuth measurement device in a three dimensional space. Therefore, quick obtainment of the offset has not been achieved yet by performing minute movement, rotation, and so forth of the azimuth measurement device.

In recent years, in addition to wide spread of portable terminal devices such as smart phones, tablet devices have been also widely spread, and accordingly, various sensors including magnetic sensors have been widely embedded in such devices. However, when an offset value of a magnetic sensor is calculated only with use of an output of such a magnetic sensor as disclosed in PTL 1, it is difficult to accurately estimate an offset by performing minute movement, rotation and so forth of a terminal device. It is thus required to move and rotate a terminal device to a relatively great extent.

When a portable terminal device is of a small type such as a smart phone, the terminal device can be relatively easily moved and rotated in a three-dimensional manner. However, a tablet device is larger than a portable terminal device such as a smart phone. It is thus difficult to move and rotate the tablet device in a three-dimensional-manner. Therefore, it has been strongly expected to implement a method of calculating an offset value of magnetic data to be outputted from a magnetic sensor andlneasuring an azimuth even by performing more slight movement, rotation and so forth of a terminal device.

In view of the above, it is an object of the present invention to provide an offset estimation device, an offset Estimation method and an information processing device, whereby an offset of geomagnetic data to be outputted by a geomagnetic sensor can be accurately estimated.

Solution to Problem

This object is achieved by the independent claims. Advantageous embodiments are described in the dependent claims.

An offset estimation device for solving the aforementioned problem is an offset estimation device according to claim 1.

Here, the aforementioned first rotation axis calculation part may be configured to carry calculations according to claims 2 to 11.

An offset estimation method for solving the aforementioned problem includes: calculations steps according to claim 12.

An offset estimation program for solving the aforementioned problem is an offset estimation program according to claim 13.

An information processing device for solving the aforementioned problem includes the aforementioned offset estimation device, a geomagnetic detection part and an angular velocity detection part, according to claim 14.

Advantageous Effects of Invention

According to the present invention, an offset of magnetic data to be outputted by a geomagnetic sensor can be accurately estimated.

Brief Description of Drawings

[Fig. 1] Fig. 1 is a diagram showing an exemplary entire schematic configuration of a physical amount measurement system according to an exemplary embodiment of the present invention;
[Fig. 2] Fig. 2 is a block diagram showing exemplary functions of an offset estimation device;
[Fig. 3] Fig. 3 is a flowchart showing an exemplary physical amount measurement action to be performed in a physical amount measurement device;
[Fig. 4] Fig. 4 is a diagram schematically showing a relation among a distribution status of geomagnetic data, an offset value and rotation axis information when time has elapsed in an environment that the magnitude of a geomagnetic field is constant;
[Fig. 5] Fig. 5 is a diagram showing an exemplary application;
Fig. 6 is a diagram schematically showing a relation among measurement data at a clock time t+2 when time has further elapsed from a clock time t+1;
[Fig. 7] Fig. 7 is a diagram schematically showing a relation among rotation axis information, a plane and so forth, calculated based on a magnetic data group measured at different clock times t, t+1 and t+2 and its relevant DCM data group;
Fig. 8 is a schematic diagram in estimating an offset from multiple rotational axes;
[Fig. 9] Fig. 9 is a diagram schematically showing a relation among a distribution status of geomagnetic data, an offset value and rotation axis information when time has elapsed in an environment that the magnitude of a geomagnetic field is constant; and
[Fig. 10] Fig. 10 is a diagram showing a circular plane 440 in Fig. 9 on a two-dimensional plane.

Description of Embodiments

(First Embodiment)

With reference to the drawings, explanation will be hereinafter made for an exemplary embodiment of a physical amount measurement system including an offset estimation device of the present invention. A physical amount measurement system 100 according to the exemplary embodiment is a system that is embedded in a portable device such as a mobile phone, a PDA (Personal Digital Assistant) or a tablet device, and is configured to estimate an offset as a signal component other than a geomagnetic field and measure an azimuth when a user moves a portable device.

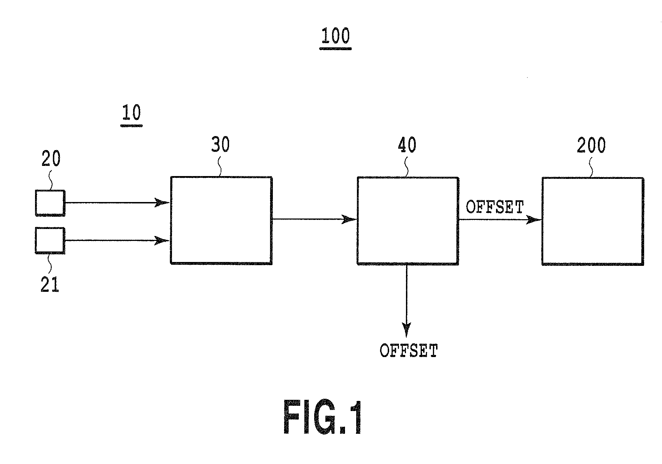

Fig. 1 is a diagram showing an exemplary entire schematic configuration of the physical amount measurement system 100.
The physical amount measurement system 100 includes a physical amount measurement device (azimuth measurement device) 10 and a computation unit 200.
The physical amount measurement device 10 includes a magnetic sensor (geomagnetic detection part) 20, a rotation amount sensor (rotation amount detection part) 21, a data obtainment unit 30 and an offset estimation device 40.
The magnetic sensor 20 is a sensor for detecting a geomagnetic field. In the present exemplary embodiment, for instance, the magnetic sensor 20 is explained as a magnetic sensor for detecting a geomagnetic field composed of three components, i.e., an X-axial component, a Y-axial component and a Z-axial component. However, the magnetic sensor 20 may be a magnetic sensor for detecting a geomagnetic field composed of four or more components.
The rotation amount sensor 21 may be of any type as long as it is capable of detecting a rotation amount and outputting rotation amount data. Angle, angular velocity, angular acceleration or so forth can be assumed as the rotation amount, whereas angular data, angular velocity data, angular acceleration data or so forth can be assumed as the rotation amount data.
The rotation amount sensor is not particularly limited to a specific type, and may be an angular sensor or an acceleration sensor. Further, it is also possible to calculate the rotation amount with use of information from a heretofore known magnetic sensor for detecting an external magnetic field. Hence, the magnetic sensor may be used as the rotation amount sensor. Yet further, a device, configured to transmit a signal when a predetermined rotation is performed, may be used as the rotation amount sensor. In the present practical example, an angular velocity sensor is used as the rotation amount sensor.

The data obtainment unit 30 is configured to obtain a vector physical amount data group composed of multiple sets of geomagnetic data and multiple sets of angular velocity data in the form of a digital signal or an analog signal by repeatedly obtaining geomagnetic data detected by the magnetic sensor 20 and angular velocity data detected by the angular velocity sensor 21.

Where the aforementioned vector physical amount data group is in the form of an analog signal, the data obtainment unit 30 of the present exemplary embodiment is configured to further perform an amplification processing, a filtering processing and an A/D conversion processing for the analog signal and output the processed signal to the offset estimation device 40. However, the data obtainment unit 30 may be configured to output an analog signal as it is without performing the A/D conversion processing. Alternatively, the data obtainment unit 30 may be configured to perform a filtering processing (e.g., an averaging processing) after the A/D conversion processing.

Similarly, where the aforementioned vector physical amount data group is in the form of a digital signal, the data obtainment unit 30 may be configured to perform a desired digital signal processing, for instance, a filtering processing (e.g., an averaging processing).

The offset estimation device 40 is configured to calculate DCM (Direction Cosine Matrix) data and various angle data (yaw angle, roll angle and pitch angle) on the basis of the aforementioned vector physical amount data group. The vector physical amount data group, the DCM data and the various angle data are stored in a memory within the offset estimation device 40.

Further, the offset estimation device 40 is configured to calculate a direction vector of a rotation axis to be described and rotation axis information to be described with use of the stored DCM data group, various angle data group and vector physical amount data group.

Moreover, the offset estimation device 40 is configured to estimate multiple reference points contained in the vector physical amount data group on the basis of the calculated rotation axis information group and estimate highly reliable one of the multiple estimated reference points as an offset.

The computation unit 200 is configured to calculate information required for the system on the basis of the vector physical amount data group obtained by the physical amount measurement device 10 and the estimated offset.

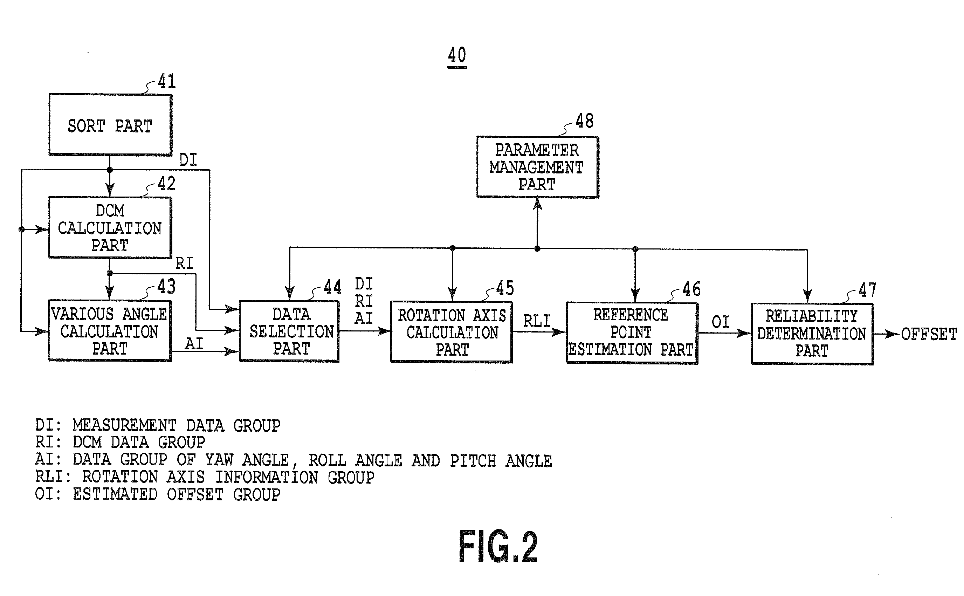

Fig. 2 is a diagram showing an exemplary configuration of the offset estimation device 40.

The offset estimation device 40 includes a sort part 41, a DCM calculation part 42, a various angle calculation part 43, a data selection part 44, a rotation axis calculation part 45, a reference point estimation part 46, a reliability determination part 47 and a parameter management part 48.

The sort part 41 is configured to obtain a vector physical amount data group D1 from the data obtainment unit 30 and sort the data composing the vector physical amount data group D1 into types in accordance with the content of a subsequent processing. In the present exemplary embodiment, the sort part 41 is configured to output the vector physical amount data group D1 to the DCM calculation part 42, the various angle calculation part 43 and the data selection part 44, respectively.

The DCM calculation part 42 is configured to calculate DCM data R1 on the basis of the vector physical amount data group inputted therein.

The various angle calculation part 43 is configured to calculate various angle data (yaw angle, roll angle, pitch angle) A1 on the basis of the DCM data R1 outputted thereto from the DCM calculation part 42.

The data selection part 44 is configured to input therein the vector physical amount data group D1 from the sort part 41, the DCM data R1 from the DCM calculation part 42, and the various angle data (yaw angle, roll angle, pitch angle) A1 from the various angle calculation part 43 and store the inputted data, for instance, in the memory.

Further, the data selection part 44 is configured to determine whether or not the aforementioned vector physical amount data group D1, DCM data group R1 and various angle data (yaw angle, roll angle, pitch angle) group A1, which are stored in the memory, for instance, satisfy a predetermined condition (whether or not the aforementioned data groups are suitable for a subsequent processing in the reference point estimation part 46) with use of parameters set in the parameter management part 48. When a data value as a determination target is less than or equal to a parameter, for instance, the data selection part 44 is configured to determine that the predetermined condition is satisfied and output the vector physical amount data group D1, the DCM data group R1 and the various angle data group A1 to the rotation axis calculation part 45.

The rotation axis calculation part 45 is configured to calculate a rotation axis direction vector composed of a predetermined coordinate system (e.g., three axes in the present exemplary embodiment) and rotation axis information composed of a rotation center coordinate with use of the vector physical amount data group D1, the DCM data group R1 and the various angle data (yaw angle, roll angle, pitch angle) group A1. The calculation processing will be described below.

Further, the rotation axis calculation part 45 is configured to determine whether or not the calculated rotation axis information is suitable data for the subsequent processing in the reference point estimation part 46, and then store the rotation axis information, for instance, in the memory when the rotation axis information is suitable for the processing.

The reference point estimation part 46 is configured to estimate the coordinates of the reference points on the basis of the calculated rotation axis information group RL1 with use of the parameters set in the parameter management part 48 by means of an analytical method. In the present exemplary embodiment, for instance, a configuration is explained that a geomagnetic field is detected with use of the tri-axis magnetic sensor 20. Hence, the center of a sphere on which the detected geomagnetic data group is distributed is referred to as a reference point.

The reliability determination part 47 is configured to determine the reliability of each reference point estimated in the reference point estimation part 46 (e.g., in the present exemplary embodiment, whether or not each reference point is estimated with an error acceptable for the system) and output one of the reference points, which is determined to be highly reliable, as an offset. Various methods can be assumed as the method of determining reliability of a reference point. However, one of them is a method of: preliminarily calculating reliability information of a reference point in accordance with parameters to be described; comparing the reliability information and a determination value; and obtaining the comparative result as an index of reliability. It should be noted that in the present exemplary embodiment, the reference point estimation part 46 and the reliability determination part 47 are collectively referred to as an offset estimation part.

The number of the aforementioned determination value may be single or plural. When multiple determination values exist, the reliability may be configured to be divided into multiple divisions on the basis of comparative results between the respective multiple determination values and the aforementioned reliability information. In this case, only an offset categorized in the highest division of reliability may be configured to be outputted. However, the present invention is not limited to the configuration. For example, where the reliability is divided into four divisions of "excellent", "good", "pass" and "fail", it may be preferable for convenience of a user to output an offset not only when the offset is categorized in "excellent" but also when the offset is categorized in "good" or "pass".

Further, the reliability determination part 47 may be configured to output the aforementioned reliability information or reliability, or alternatively, may be configured to output both of the reliability information and the reliability.

The parameter management part 48 is configured to manage various parameters related to offset estimation. The parameter management part 48 is configured to manage behavior of the entire offset estimation device 40 by changing the various parameters related to offset estimation on the basis of a processing status in the offset estimation device 40 so as to be capable of estimating an optimal offset suitable for the processing status.

For example, the parameters include a measurement parameter, a determination value, a calculation parameter and so forth, and these parameters are stored in the form of table while being associated with some levels.

The parameter management part 48 may be configured to select one of the multiple levels in accordance with a processing status and manage the behavior of a physical amount measurement device 100 on the basis of the parameters indicated with the aforementioned selected level. Alternatively, the parameter management part 48 may be configured to consecutively change various items of parameters in accordance with a processing status. Yet alternatively, the parameter management part 48 may be configured to output a management status of parameters currently used.

Explanation will be hereinafter made for an action of the physical amount measurement device 10 of the present exemplary embodiment.

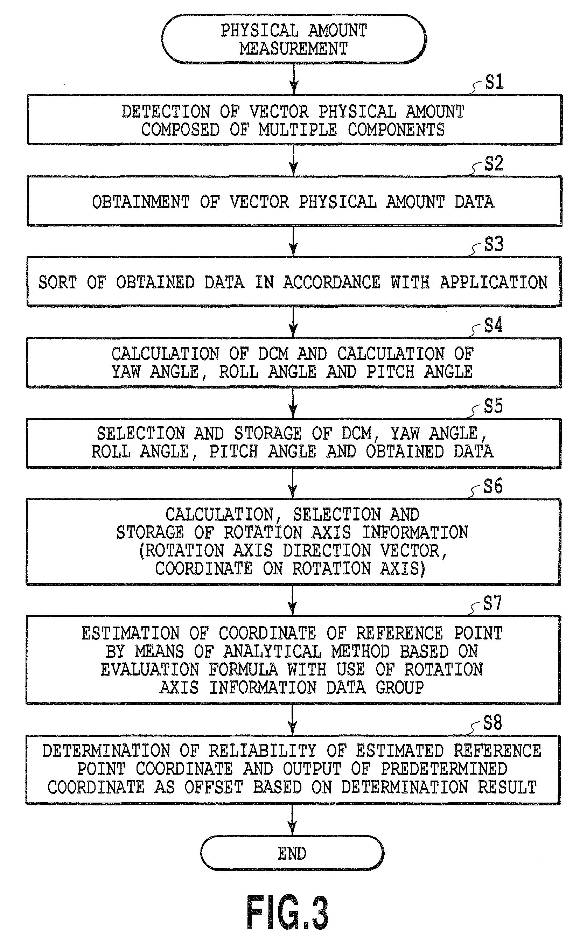

Firstly, with reference to Fig. 3, explanation will be made for an action of the physical amount measurement device 10 in a physical amount measuring processing.

Fig. 3 is a flowchart showing an action of measuring a physical amount to be performed in the physical amount measurement device 10.

In Step S1, a vector physical amount composed of multiple components is detected. Specifically, the magnetic sensor 20 detects a geomagnetic field composed of three components, whereas the angular velocity sensor 21 detects an angular velocity.

In Step S2, the data obtainment unit 30 obtains the detected vector physical amount. In the present exemplary embodiment, the data obtainment unit 30 performs, for instance, an amplification processing, a filtering processing and an A/D conversion processing in accordance with the type of the obtained data in order to allow the offset estimation device 40 to easily perform processing.

In Step S3, the sort part 41 of the offset estimation device 40 sorts the multiple types of vector physical amount data obtained in the data obtainment unit 30 and output the sorted data to a subsequent processing block.

In Step S4, the offset estimation device 40 calculates the DCM data and various angle data with use of the vector physical amount data sorted in Step S3. Specifically, the DCM calculation part 42 of the offset estimation device 40 calculates the DCM data R1 on the basis of the inputted vector physical amount, whereas the various angle calculation part 43 of the offset estimation device 40 calculates the various angle data (yaw angle, roll angle, pitch angle) A1 on the basis of the DCM data R1 outputted thereto from the DCM calculation part 42.

In Step S5, the data selection part 44 of the offset estimation device 40 determines whether or not the DCM data and the various angle data calculated in Step S4 and the vector physical amount data sorted in Step S3 are suitable data for a processing to be performed in the reference point estimation part 46. As a result, when the aforementioned data are determined to be suitable for the processing, the data selection part 44 selects the DCM data, the various angle data and the vector physical amount data and stores them, for instance, in the memory.

In Step S6, the rotation axis calculation part 45 of the offset estimation device 40 calculates a rotation axis direction vector and rotation axis information composed of a coordinate on a rotation axis on the basis of the DCM data group, the various angle data group and the vector physical amount data group. Further, the rotation axis calculation part 45 determines whether or not the calculated rotation axis information data is suitable data for the processing to be performed in the reference point estimation part 46. As a result, when the calculated rotation axis information data is determined to be suitable for the processing, the rotation axis calculation part 45 stores the rotation axis information, for instance, in the memory.

In Step S7, the reference point estimation part 46 of the offset estimation device 40 estimates reference points contained in the vector physical amount data group with use of the rotation axis information group on the basis of a predetermined evaluation formula.

In Step S8, the reliability determination part 47 of the offset estimation device 40 determines reliabilities for the coordinates of the estimated reference points and outputs a reference point determined to be highly reliable as an offset.

[Action of Parameter Management Part]

Next, explanation will be made for an action of the parameter management part 48.

When variation in internal status of the physical amount measurement device 10 or variation in measurement environment of the physical amount measurement device 10 is detected, the parameter management part 48 is configured to change parameters to be used in accordance with the detected result.

[Action of Offset Estimation Device]

Next, explanation will be made for an action of the offset estimation device 40.

The offset estimation device 40 calculates the DCM data on the basis of one of the at least two types of measurement data obtained by the data obtainment unit 30, and calculates the yaw angle, the roll angle and the pitch angle from the calculated DCM data. Further, the offset estimation device 40 stores the DCM data, the yaw angle, the roll angle, the pitch angle and the measurement data, for instance, in the memory on an as-needed basis. In a preliminarily set procedure, the offset estimation device 40 estimates reference points contained in one of the at least two types of data to be outputted by the data obtainment unit 30 on the basis of the stored DCM data group, various angle data group (yaw angle, roll angle, pitch angle) and measurement data group; determines the reliability of each reference point; and outputs an appropriate reference point as an offset. Here, the yaw angle, the roll angle and the pitch angle are calculated on the basis of the calculated DCM data. However, the yaw angle, the roll angle and the pitch angle are obviously allowed to be calculated with another method.

In the present exemplary embodiment, an offset can be estimated even in minute movement, rotation or action in the three dimensional space by performing computation in a set procedure with use of the DCM data group, the various angle data group (yaw angle, roll angle, pitch angle) and the measurement data group, compared to a configuration of estimating an offset contained in the measurement data group on the basis of only one type of measurement data group.

As the measurement data for calculating the DCM data and the various angle data (yaw angle, roll angle, pitch angle), data obtained by the data obtainment unit 30 may be used as it is, or alternatively, data may be used that is obtained by performing some sort of computation processing (e.g., an averaging processing) with respect to the measurement data group in order to reduce influence of noise. Similarly, as the measurement data to be used in calculating the rotation axis information, data obtained by the data obtainment unit 30 may be used as it is, or alternatively, data may be used that is obtained by performing some sort of computation processing (e.g. , an averaging processing) with respect to the measurement data group in order to reduce influence of noise.

Further, it is obvious that as the DCM data and the various angle data (yaw angle, roll angle, pitch angle) to be used in calculating the rotation axis information, the DCM data calculated by the DCM calculation part 42 and the various angle data (yaw angle, roll angle, pitch angle) calculated by the various angle calculation part 43 may be used as they are, or alternatively, data may be used that is obtained by performing some sort of computation processing (e.g., an averaging processing) with respect to the DCM data group and the yaw angle, roll angle and pitch angle data group, which are calculated for reducing an error to be produced in calculation and reducing variation attributed to noise included in the measurement data.

[Action of Computation Unit 200]

In the physical amount calculation system 100 shown in Fig. 1, the computation unit 200 normally receives the measurement data obtained by the data obtainment unit 30 of the physical amount measurement device 10 and the offset estimated by the reference point estimation device 40, and calculates information required for the system.

For example, in the case of an azimuth measurement device that includes a tri-axis magnetic sensor as the magnetic sensor 20 and is intended to detect a geomagnetic field to calculate an azimuth, a value of the geomagnetic field is firstly calculated and the azimuth is then calculated based on the estimated offset and the obtained measurement data.

Specifically, where the offset outputted from the reliability determination part 47 is set as $O = (O_x, O_y, O_z)$; and the magnetic measurement data is set as $M = (M_x, M_y, M_z)$ when a portable device equipped with the physical amount measurement system 100 is horizontally disposed (such that an x measurement axis and a y measurement axis of the magnetic sensor are located on a horizontal plane), an azimuth $\theta$ with respect to the magnetic north of the x measurement axis is expressed with the following formula.

[Math. 1]

$$\theta = \tan^{-1}\left(\frac{-M_y - O_y}{M_x - O_x}\right)$$

It should be noted that, even when the portable device equipped with the physical amount measurement system 100 is not located on the horizontal plane, it is obviously possible to calculate the azimuth $\theta$ with respect to the magnetic north of the x measurement axis.

[Processing to Be Performed in Estimating Reference Point]

When geomagnetic data is obtained with use of the tri-axis magnetic sensor 20 in the environment that the magnitude of a magnetic field is constant as described above, the measurement data of the geomagnetic field is distributed on a sphere.

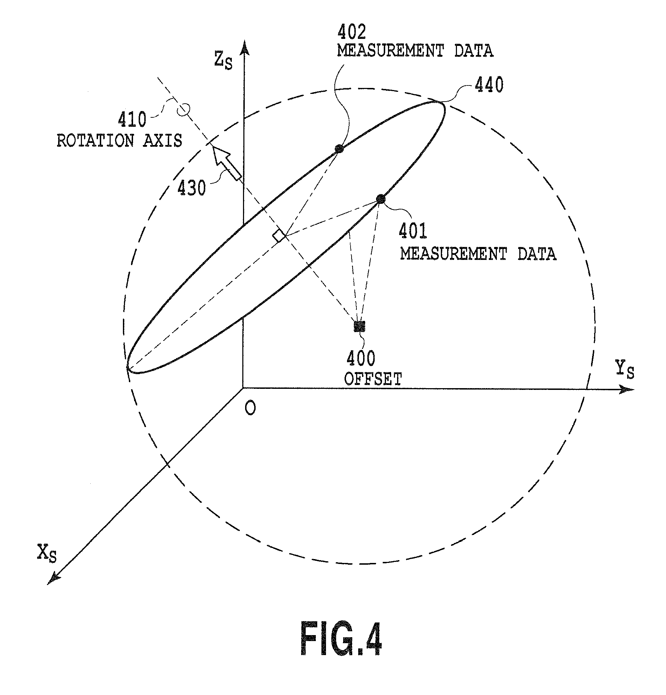

Fig. 4 is a diagram schematically showing a relation among a distribution status of geomagnetic field data, an offset value and rotation axis information when time has elapsed in an environment that the magnitude of a geomagnetic field is constant.

An Xs axis, a Ys axis and Zs axis, shown in Fig. 4, are coordinate axes arranged perpendicularly to each other. In the present exemplary embodiment, three coordinate axes of the data outputted from the magnetic sensor 20 and those of the data outputted from the angular velocity sensor 21 respectively correspond to the aforementioned Xs axis, Ys axis and Zs axis, or alternatively, are respectively data-converted so as to correspond to the aforementioned Xs axis, Ys axis and Zs axis.

Magnetic data measured by the magnetic sensor 20 at a clock time t, i.e., measurement data 401 and magnetic data measured by the magnetic sensor 20 at a clock time t+1, i.e., measurement data 402 are distributed on a sphere centered at an offset 400 contained in the data group of the magnetic sensor 20, while being distributed on a circular-arc of a circular plane 440 arranged perpendicularly to a rotation axis 410 passing through the offset 400. Further, the rotation axis 410 can be expressed by a direction vector 430 of the rotation axis 410 and a coordinate existing on the rotation axis 410.

It should be noted that the rotation axis 410 is calculated by the aforementioned rotation axis calculation part 45 (first rotation axis linear calculation part).

In the present exemplary embodiment, as an exemplary configuration, the rotation axis 410 for estimating the offset 400 is configured to be obtained by calculating a rotation axis direction vector and a coordinate on the rotation axis from the DCM data calculated based on both of the magnetic data 401 measured at the clock time t and the angular velocity data of the angular velocity sensor 21 and the DCM data calculated based on both of the magnetic data 402 measured at the clock time t+1 and the angular velocity data of the angular velocity sensor 21. The processing of obtaining the rotation axis 410 will be described below.

Further, the various angle data (yaw angle, roll angle, pitch angle) at the clock time t can be calculated with use of the DCM data to be calculated from the angular velocity data at the clock time t. Likewise, the various angle data (yaw angle, roll angle, pitch angle) at the clock time t+1 can be calculated. Therefore, it is possible to calculate to what extent the posture of the portable terminal device equipped with the physical amount measurement system 100 has been rotated at the yaw angle, the roll angle and the pitch angle in a meantime from the clock time t to the clock time t+1 by calculating differential angles between two sets of various angle data (yaw angle, roll angle, pitch angle). Accordingly, it is possible to determine the extent of variation in posture of the portable terminal device.

In this case, comparison is performed with respect to the calculation parameters set in the parameter management part 48; only the data group corresponding to where the portable terminal device is rotated at a predetermined angle or greater, for instance, is determined from the comparison result; and the rotation axis information is obtained with use of only the data group. Accordingly, it is possible to easily exclude data unsuitable for a subsequent processing of reference point estimation such as data corresponding to where the portable terminal device is unmoved or slightly moved. As a result, this contributes to enhancement of accuracy in reference point estimation.

In this case, it can be easily assumed that, for instance, under a condition that only magnetic data is fluctuated due to disturbance of magnetic field, when offset estimation is performed only with the magnetic data, the estimated offset value is inevitably deviated from a true offset value to a great extent. However, such a conventionally unsolved situation unsuitable for offset estimation can be excluded with the method explained in the present exemplary embodiment and in further consideration of the data from the angular velocity sensor 21.

Here, the various angle data (yaw angle, roll angle, pitch angle) are calculated from the DCM data, and the differential data of the yaw angle, the roll angle and the pitch angle are set as an indicator of the action of the portable terminal device. However, it may be determined to what extent the portable terminal device has been moved with use of cumulative angles about the respective axes in the angular velocity data. Alternatively, the extent of variation in posture of the portable terminal device may be determined with use of the magnetic sensor data, the acceleration sensor data and so forth.

[Processing to Be Performed in Calculating Rotation Axis Information]

Next, the method of obtaining the rotation axis 410 will be specifically explained with mathematical formulas. Here, the magnetic data 401 measured at the clock time t is set as $A = (A_x, A_y, A_z)^T$, whereas the magnetic data 402 measured at the clock time t+1 is set as $B = (B_x, B_y, B_z)^T$. It should be noted that A and B are set as values in a sensor coordinate system. AT indicates a transpose of A, whereas $B^T$ indicates a transpose of B.

On the other hand, in a global coordinate system, a value corresponding to the magnetic data 401 in the global coordinate system is set as $A_G$, whereas a value corresponding to the magnetic data 402 in the global coordinate system is set as $B_G$. Further, DCM data 451 to be calculated based on the angular velocity data measured at the clock time t is set as $R_A$, whereas DCM data 452 to be measured based on the angular velocity data measured at the clock time t+1 is set as $R_B$. Yet further, when tri-axis data is handled, the DCM data is expressed with a 3x3 matrix and is generally defined as the following formula.

[Math. 2]

$$R = \begin{bmatrix} r'_{xx} & r'_{xy} & r'_{xz} \\ r'_{yx} & r'_{yy} & r'_{yz} \\ r'_{zx} & r'_{zy} & r'_{zz} \end{bmatrix}$$

Firstly, explanation will be made for a method of calculating the DCM data defined by Math. 2 from the angular velocity data. Where the DCM data at the clock time t is set as $R_A$; the DCM data at the clock time t+1 is set as $R_B$; the angular velocity data at the clock time t+1 is set as $\omega = (\omega_x, \omega_y, \omega_z)^T$; and an angular velocity sensor measurement time interval is set as $\Delta t$, $R_t$ can be obtained with $R_{t-1}$ and the angular velocity data $\omega$ as defined in Math. 3. It should be noted that the unit of the angular velocity data is (rad/sec), whereas the unit of $\Delta T$ is (sec).

[Math. 3]

$$R_B = R_A + R_A \begin{bmatrix} 0 & -\omega_z & \omega_y \\ \omega_z & 0 & -\omega_x \\ -\omega_y & \omega_x & 0 \end{bmatrix} \Delta T$$

In accordance with Math. 3, the DCM data ($R_A$) 451 at the clock time t and the DCM data ($R_B$) 452 at the clock time t+1 can be respectively calculated. Further, chances are that as time elapses, the DCM data calculated in accordance with Math. 3 lose its orthogonality due to problems of computation accuracy and so forth. Therefore, a computation processing for maintaining orthogonality may be performed after calculation of the DCM data.

Further, the DCM data is herein calculated directly using the data of the angular velocity sensor as shown in Math. 3. However, there is also nothing wrong with a configuration of calculating the DCM data using, for instance, the various angle data (yaw angle, roll angle, pitch angle), quaternion or so forth. Yet further, there is also nothing wrong with a configuration of calculating the DCM data with use of another means such as an acceleration sensor capable of calculating the rotation amount instead of the angular velocity sensor.

The explanation of the present exemplary embodiment premises the configuration that sampling is consecutively performed for the magnetic data and the angular velocity data at the clock time t and the clock time t+1. However, such a processing may not be required when correspondence is established between the obtaining time of the magnetic data and that of the angular velocity data. In other words, the obtaining time of the magnetic data and that of the angular velocity data may be shifted from each other as long as it is possible to achieve the advantageous effect of the present invention, i.e., the effect of enabling accurate estimation of the offset of the geomagnetic sensor.

Further, the present exemplary embodiment is described by exemplifying a configuration of increasing the sampling time by only the minimum amount as with the clock time t and the clock time t+1. However, time difference between the clock time t and the clock time t+1 may not be the minimum sampling time amount.

Further, when the time difference between the clock time t and the clock time t+1 is set not to be the minimum sampling time amount but to be an arbitrary time difference, two sets of angular velocity data at the clock time t and the clock time t+1, or alternatively, arbitrary number of sets of angular velocity data obtained from the clock time t to the clock time t+1 may be used, for instance, as exemplary angular velocity data to be used in obtaining the DCM data.

Further, in obtaining multiple sets of DCM data, i.e., the DCM data ($R_A$), the DCM data ($R_B$) and so forth, it is preferable to calculate the multiple sets of DCM data with reference to the DCM data at the same clock time from the perspective of maintaining the relation among the multiple sets of DCM data. For example, the identity matrix and so forth can be assumed as the DCM data to be referred, but the DCM data composed of desired values may be set as the reference. Further, the clock time of the DCM data to be referred may be changed when it is no longer required to maintain the relation among the multiple sets of DCM data or when necessity to reset the relation is emerged, for instance, when a magnetic field condition varies or when a magnetizing condition varies.

With use of the DCM data ($R_A$) 451 and the DCM data ($R_B$) 452, relation between magnetic data A and magnetic data $A_G$ and that between magnetic data B and magnetic data $B_G$ can be defined as the following formulas.

[Math. 4]

$$A_G = R_A A$$

[Math. 5]

$$B_G = R_B B$$

The magnetic data A, B can be expressed with the following formulas, where an offset value is contained in a magnetic measurement value (the magnetic data A, the magnetic data B) in the sensor coordinate system; and an offset value is set as $b_0$ and a geomagnetic field value is set as $b_c$. It should be noted that $R_A{}^T$ indicates a transpose of $R_A$.

[Math. 6]

$$A = b_0 + R_A{}^T b_c$$

[Math. 7]

$$B = b_0 + R_B{}^T b_c$$

Here, when the both sides of Math. 6 are multiplied by $R_A$ whereas the both sides of Math. 7 are multiplied by $R_B$, resultant formulas are as shown in Maths. 8 and 9. Then, Math. 10 is derived from the both formulas.

[Math. 8]

$$R_A A = R_A b_0 + b_c$$

[Math. 9]

$$R_B B = R_B b_0 + b_c$$

[Math. 10]

$$R_A A - R_B B = (R_A - R_B) b_0$$

Next, explanation will be made for a displacement between sets of magnetic data in terms of expression with the DCM data. In Maths. 6 and 7, an example is explained that the offset is contained in the measured magnetic sensor data.
Where the magnetic data A is substituted by A' while the magnetic data B is substituted by B' as magnetic data obtained by subtracting the offset value $b_0$ from the magnetic data A, B, the relation between magnetic data can be expressed as follows.

[Math. 11]

$$A' = R_A{}^T b_c$$

[Math. 12]

$$B' = R_B{}^T b_c$$

Maths. 11 and 12 are respectively solved for $b_c$ and the result is substituted to these formulas, the following formula is derived.

[Math. 13]

$$R_A A' = R_B B'$$

When the formula is further solved for A' and B', results can be expressed Maths. 14 and 15.

[Math. 14]

$$A' = R_A{}^T R_B B'$$

[Math. 15]

$$B' = R_B{}^T R_A A'$$

Considering the magnetic data obtained by subtracting the offset value $b_0$ from the original magnetic data, a displacement between two points can be expressed with the DCM data on the basis of Maths. 14 and 15. Where the displacement from A to B is set as $\Delta R_{BA}$, the magnetic data can be expressed with Maths. 16 and 17.

[Math. 16]

$$A' = \Delta R_{BA}{}^T B'$$

[Math. 17]

$$B' = \Delta R_{BA} A'$$

Next, the both sides of Math. 10 are multiplied by $R_A{}^T$. Likewise, the both sides of Math. 10 are multiplied by $R_B{}^T$. Further, differential between two resultant formulas is calculated. The result is shown as follows. It should be noted that the following formulas are organized with use of the relations in Maths. 14 to 17.

[Math. 18]

$$R_A{}^T R_A A - R_A{}^T R_B B = R_A{}^T (R_A - R_B) b_0$$

[Math. 19]

$$R_B{}^T R_A A - R_B{}^T R_B B = R_B{}^T (R_A - R_B) b_0$$

[Math. 20]

$$A + B - \left(\Delta R_{BA} A + \Delta R_{BA}{}^{T} B\right) = \left(2 - \Delta R_{BA}{}^{T} - \Delta R_{BA}\right) b_0$$

The value of $b_0$ can be obtained if it is possible to obtain an inverse of a 3x3 matrix expressed as $(R_A - R_B)$ in the right side of Math. 10. However, in principle, a determinant of the matrix $(R_A - R_B)$ obtained in the present exemplary embodiment is 0. Therefore, it is known that the inverse is unobtainable. However, it is possible to obtain a direction vector of a perpendicular with respect to the rotation axis in transition from A to B on the basis of Math. 20. The direction vector can be expressed with the following formula. In other words, a coordinate (P) on the rotation axis 410 can be expressed.

[Math. 21]

$$P = \frac{A + B - \left(\Delta R_{BA} A + \Delta R_{BA}{}^{T} B\right)}{3 - Trace(\Delta R_{BA})}$$

Next, a rotation axis direction vector ($n = (n_x, n_y, n_z)$) 430 can be expressed with Math. 23, where elements of the differential DCM data ($R_{BA}$) 453 are defined by Math. 22.

[Math. 22]

$$R_{BA} = \begin{bmatrix} r'_{xx} & r'_{xy} & r'_{xz} \\ r'_{yx} & r'_{yy} & r'_{yz} \\ r'_{zx} & r'_{zy} & r'_{zz} \end{bmatrix}$$

[Math. 23]

$$n = \begin{pmatrix} n_x \\ n_y \\ n_z \end{pmatrix} = \begin{pmatrix} r'_{zy} - r'_{yz} \\ r'_{xz} - r'_{zx} \\ r'_{yx} - r'_{xy} \end{pmatrix}$$

It should be noted that a direction unit vector of the rotation axis 410 can be obtained by normalizing the rotation axis vector expressed with Math. 23. It should be noted that the vector expressed with Math. 23 is normalized in the present exemplary embodiment, but advantageous effect of the present exemplary embodiment is not negatively affected even without performing normalization in expressing the rotation axis with a mathematical formula.

Further, in the present exemplary embodiment, as described above, it is possible to obtain to what extent the posture of the portable terminal device equipped with the physical amount measurement system 100 has been rotated in a meantime from the clock time t to the clock time t+1 by obtaining, for instance, a differential angle between two yaw angles, that between two roll angles and that between two pitch angles.

It should be noted that in the first exemplary embodiment and the second exemplary embodiment, a time period corresponding to a meantime between the clock time t and the clock time t+1 includes not only the exact meantime between the clock time t and the clock time t+1 but also a period obtained by increasing or reducing the meantime between the clock time t and the clock time t+1 to some extent.

However, it is possible to exclude rotation axis information unsuitable for reference point estimation by setting the scalar amount of the rotation axis direction vector as an indicator in order to further enhance accuracy.

In the present exemplary embodiment, determination using the yaw angle, the roll angle and the pitch angle and determination using the scalar amount of the rotation axis direction vector are performed in two stages. The two-stage determination is performed by performing the determination using the yaw angle, the roll angle and the pitch angle in the earlier stage in order to reduce the computation amount required for obtaining the scalar amount of the rotation axis direction vector. However, determination may be performed with use of only either of the methods, and alternatively, rotation axis information to be used for estimation may be selected in the subsequent stage of estimating a reference point.

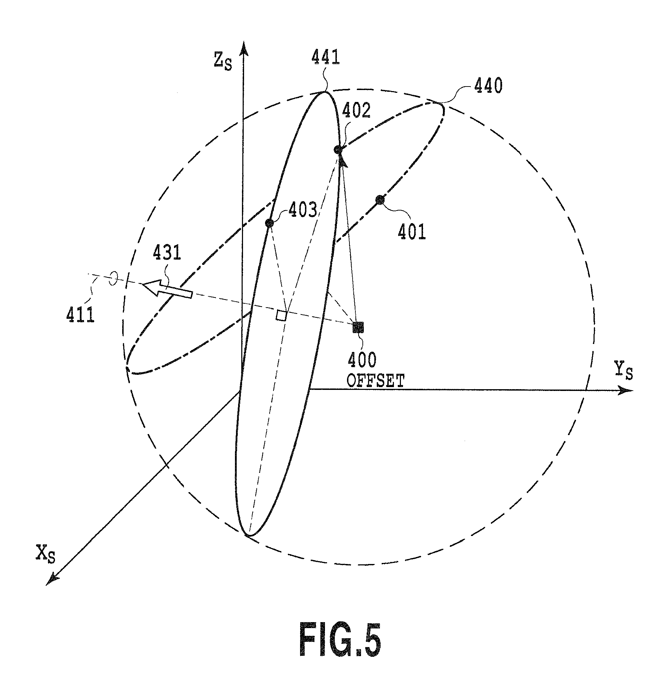

Next, with reference to Figs. 5 to 7, explanation will be made for a procedure of estimating an offset from the calculated rotation axis information.

Fig. 5 is a diagram schematically showing a relation among measurement data (magnetic data) at a clock time t+2 when time has further elapsed from the clock time t+1.

The magnetic data 402 measured at the clock time t+1 and magnetic data 403 measured at the clock time t+2 are distributed on a circular arc of a circular plane 441 arranged perpendicularly to a rotation axis 411 passing through the offset 400. It should be noted that the rotation axis 411 is calculated by the aforementioned rotation axis calculation part 45 (second rotation axis linear calculation part).

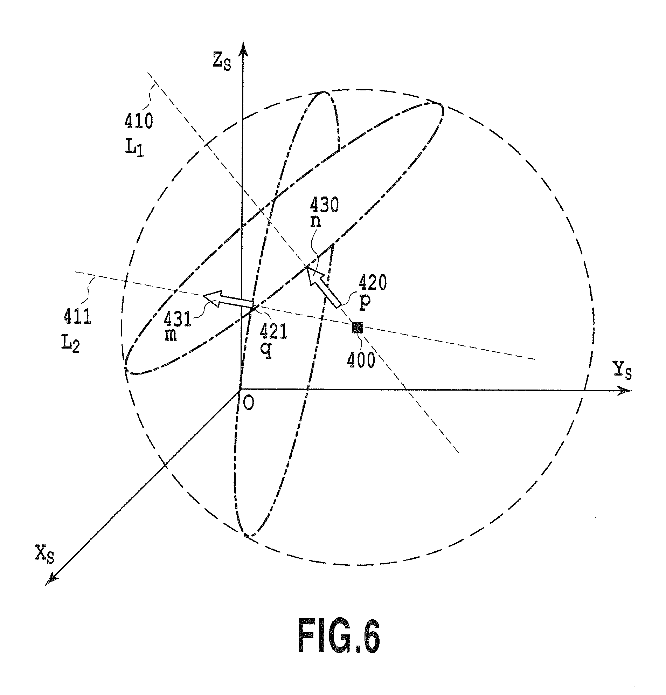

Fig. 6 is a diagram schematically expressing a relation among the rotation axes 410 and 411, the planes 440 and 441, and so forth calculated from the magnetic data group measured at the clock time t, the clock time t+1 and the clock time t+2 and its relevant DCM data group.

Based on the method described above, where the direction vector 430 of the rotation axis (L1) 410 is set as $n = (n_x, n_y, n_z)$; a coordinate on the rotation axis (L1) 410 is set as $p = (p_x, p_y, p_z)$; a direction vector 431 of a rotation axis (L2) 411 is set as $m = (m_x, m_y, m_z)$ ; and a coordinate on the rotation axis (L2) 411 is set as $q = (q_x, q_y, q_z)$, linear equations of the respective rotation axes can be expressed with the following formulas.

[Math. 24]

$$L_1 = p + sn = \begin{pmatrix} p_x \\ p_y \\ p_z \end{pmatrix} + s \begin{pmatrix} n_x \\ n_y \\ n_z \end{pmatrix} \quad (s : \text{VARIABLE})$$

[Math. 25]

$$L_2 = q + tm = \begin{pmatrix} q_x \\ q_y \\ q_z \end{pmatrix} + t \begin{pmatrix} m_x \\ m_y \\ m_z \end{pmatrix} \quad (t : \text{VARIABLE})$$

Explanation will be hereinafter made for a method of estimating an offset value on the basis of a coordinate value to which multiple rotation axes are converged in respective conditions where two rotation axes are used and where three or more rotation axes are used.

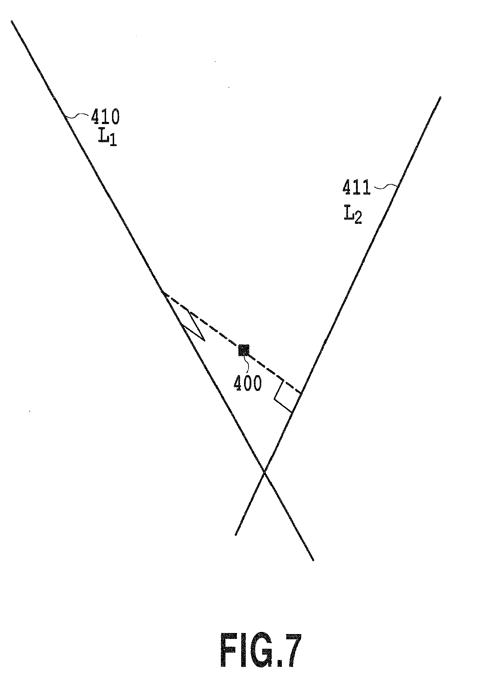

Fig. 7 is a schematic diagram in estimating the offset 400 from the rotation axes 410 and 411 respectively expressed with Maths. 24 and 25.

It should be noted that in the present exemplary embodiment, the phrase "the rotation axes are converged" encompasses not only a condition that multiple rotation axes intersect but also a condition that multiple rotation axes are skew.

When the measured magnetic sensor data group and angular velocity sensor data group do not contain noise and so forth and are ideal data groups, the two rotation axes 410 and 411 intersect with each other. However, noise is actually often mixed into sensor data to be measured. Hence, in the positional relation between the rotation axes obtained by the method described above, the rotation axes are often skew.

Firstly, explanation will be made for the condition where an offset value is estimated from the two rotation axes 410 and 411. A coordinate of the offset 400 to be estimated is a coordinate with minimum spatial distances to the two rotation axes 410 and 411. The offset coordinate is herein set as a variable, and perpendiculars are respectively extended from the offset coordinate to the two rotation axes 410 and 411. Then, the spatial distances from the offset coordinate to the feet of the perpendiculars are calculated, and such a coordinate that the sum of the spatial distances is minimized may be set as the coordinate of the offset 400. The method herein described is illustrative only. For example, there is no problem if the offset coordinate is obtained such that the sum of square distances from the offset coordinate set as the variable to the feet of the perpendiculars is minimized or if a straight line perpendicular to the two rotation axes 410 and 411 is obtained and the middle of two coordinates in which the straight line and the rotation axes 410 and 411 intersect is obtained as the offset coordinate.

Next, explanation will be made for the condition where an offset value is estimated with use of three or more rotation axes. The offset coordinate is herein set as a variable, and the spatial distances from the offset coordinate to the feet of perpendiculars extended from the offset coordinate to the respective rotation axes are calculated. Then, such a coordinate that the sum of the spatial distances is minimized may be set as the offset coordinate. The method herein described is illustrative only. For example, the offset coordinate may be obtained such that the sum of square distances from the offset coordinate set as the variable to the feet of the perpendiculars is minimized. Such a method may be employed that results in an advantageous effect equivalent to that achieved by the present invention without calculating the offset value by setting the spatial distance as an indicator, for instance, by setting a given sphere and further setting the center coordinate of the sphere as the offset coordinate when the number of rotation axes passing through the sphere is maximized.

Further, in estimating the offset with use of multiple rotation axes, a processing is obviously allowed to be performed that only a rotation axis suitable for offset estimation is extracted based on the features of the respective rotation axes in order to further enhance estimation accuracy.

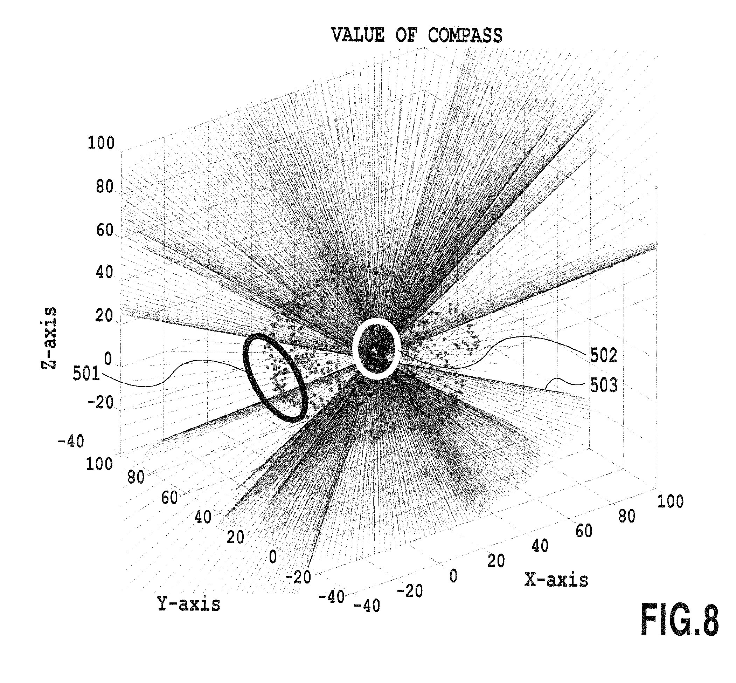

Fig. 8 is a diagram that, where rotation axis information is calculated from measured magnetic sensor data group and measured angular velocity sensor data group in accordance with the aforementioned method, then measured magnetic data group, estimated offset coordinate group and the rotation axis information used for estimation are plotted as straight lines.

A case is herein exemplified that a portable terminal device embedded with the physical amount measurement system 100 is rotated in a normal office environment.

Referring to Fig. 8, it is understood that measured magnetic data 501 are spherically distributed, whereas multiple rotation axes 503 calculated in accordance with the procedure of the present method are radially distributed about an estimated offset coordinate 502. This indicates that the offset estimation method employed in the present exemplary embodiment normally functions.

The exemplary embodiment has been described above in detail. However, the specific configuration is not limited to the above, and includes design changes without departing from the scope of the present invention, application to other purposes, and so forth.

For example, the offset estimation device 40 has been explained by exemplifying the configuration that the offset estimation device 40 is embedded in the physical amount measurement device 10. However, the offset estimation device may be configured as a stand-alone device.

Explanation has been made for the configuration that the offset estimation device 40 estimates the offset on the basis of the magnetic data and the angular velocity data at the clock time t1, those at the clock time t+1, and those at the clock time t+2. However, the offset may be estimated, for instance, on the basis of the magnetic data and the angular velocity data at the clock time t1, those at the clock time t+1, those at the clock time t+2 and those at a clock time t+3 (or in addition, those at a clock time thereafter). Alternatively, when the rotation axis is obtained, it may be configured to select an arbitrary magnetic data group (e.g., (t, t+1) and (t, t+2)) from multiple sets of magnetic data. When multiple rotation axes are calculated, the offset can be estimated unless all the rotation axes are identical. In other words, the offset can be estimated as long as there exists at least a pair of rotation axes different from each other.

Further, where multiple direction cosine matrices are respectively set as A, B, C and D, then information based on first angular velocity data may be set as information based on a differential direction cosine matrix $B^T A$ or $A^T B$ whereas information based on second angular velocity data may be set as information based on a differential direction cosine matrix $D^T C$ or $C^T D$.

The direction cosine matrix may be set so as to contain both of a conversion matrix from the sensor coordinate system to the global coordinate system and a conversion matrix from the global coordinate system to the sensor coordinate system.

The direction cosine matrix may be defined as the conversion matrix from the sensor coordinate system to the global coordinate system or may be defined as the conversion matrix from the global coordinate system to the sensor coordinate system. Incidentally, the present exemplary embodiment has explained the condition where the direction cosine matrix is defined as the conversion matrix from the sensor coordinate system to the global coordinate system. However, even if the direction cosine matrix is defined as a matrix converted via a coordinate system other than the sensor coordinate system and the global coordinate system, the advantageous effect of the present invention is not thereby negatively affected.

As described above, the first exemplary embodiment relates to explanation of an offset estimation device that estimates an offset of magnetic data to be outputted from a tri-axis geomagnetic detection part and is characterized in comprising:

a first rotation axis calculation part being configured to obtain magnetic data at a first clock time and magnetic data at a second clock time, both of which are outputted from the geomagnetic detection part, and rotation amount data being set as data in accordance with a rotation amount of the geomagnetic detection part in a time period corresponding to a meantime between the first clock time and the second clock time, the first rotation axis calculation part being configured to, in a coordinate space containing respective axial components of the magnetic data to be outputted from the geomagnetic detection part as coordinate values, calculate a first rotation axis in transition from a coordinate value based on the magnetic data at the first clock time to a coordinate value based on the magnetic data at the second clock time on the basis of the magnetic data at the first clock time, the magnetic data at the second clock time and the rotation amount data in the time period corresponding to the meantime between the first clock time and the second clock time;

a second rotation axis calculation part being configured to obtain magnetic data at a third clock time and magnetic data at a fourth clock time, both of which are outputted from the geomagnetic detection part, and rotation amount data being set as data in accordance with a rotation amount of the geomagnetic detection part in a time period corresponding to a meantime between the third clock time and the fourth clock time, the second rotation axis calculation part being configured to, in the coordinate space containing the respective axial components of the magnetic data to be outputted from the geomagnetic detection part as coordinate values, calculate a second rotation axis in transition from a coordinate value based on the magnetic data at the third clock time to a coordinate value based on the magnetic data at the fourth clock time on the basis of the magnetic data at the third clock time, the magnetic data at the fourth clock time and the rotation amount data in the time period corresponding to the meantime between the third clock time and the fourth clock time; and

an offset estimation part being configured to estimate the offset of the magnetic data of the geomagnetic detection part on the basis of a coordinate value with minimum spatial distances to the first rotation axis and the second rotation axis.

When described in more detail, the first exemplary embodiment relates to explanation of the offset estimation device that the first rotation axis calculation part is configured to:

calculate a direction vector of the first rotation axis on the basis of the rotation amount data being set as the data in accordance with the rotation amount of the geomagnetic detection part in the time period corresponding to the meantime between the first clock time and the second clock time;

calculate a coordinate value on the first rotation axis on the basis of the magnetic data at the first clock time, the magnetic data at the second clock time and the rotation amount data being set as the data in accordance with the rotation amount of the geomagnetic detection part in the time period corresponding to the meantime between the first clock time and the second clock time; and

calculate the first rotation axis on the basis of the direction vector of the first rotation axis and the coordinate value on the first rotation axis.

When described in more detail, the first exemplary embodiment relates to explanation of the offset estimation device that the second rotation axis calculation part is configured to:

calculate a direction vector of the second rotation axis on the basis of the rotation amount data being set as the data in accordance with the rotation amount of the geomagnetic detection part in the time period corresponding to the meantime between the third clock time and the fourth clock time;

calculate a coordinate value on the second rotation axis on the basis of the magnetic data at the third clock time, the magnetic data at the fourth clock time and the rotation amount data being set as the data in accordance with the rotation amount of the geomagnetic detection part in the time period corresponding to the meantime between the third clock time and the fourth clock time; and

calculate the second rotation axis on the basis of the direction vector of the second rotation axis and the coordinate value on the second rotation axis.

(Second Exemplary Embodiment)

Explanation will be hereinafter made for an exemplary embodiment of an offset estimator of the present invention.

In the present exemplary embodiment, components equivalent to those of the first exemplary embodiment will not be explained, and may be explained on an as-needed basis with use of the drawings, the mathematical formulas and so forth described in the first exemplary embodiment.

In the first exemplary embodiment, the magnetic data measured by the magnetic sensor 20 at the clock time t (i.e., the measurement data 401) and the magnetic data measured by the magnetic sensor 20 at the clock time t+1 (i.e. , the measurement data 402) are distributed on the sphere centered at the offset 400 contained in the data group of the magnetic sensor 20, while being distributed on the circular arc of the circular plane 440 arranged perpendicularly to the rotation axis 410 passing through the offset 400. In this case, the rotation axis 410 in the first exemplary embodiment can be expressed with the direction vector 430 of the rotation axis 410 and a coordinate existing on the rotation axis 410.

Compared to the above, in the present exemplary embodiment, the rotation axis 410 can be expressed with a center coordinate 471 of the circular plane 440 and a coordinate existing on the rotation axis 410.

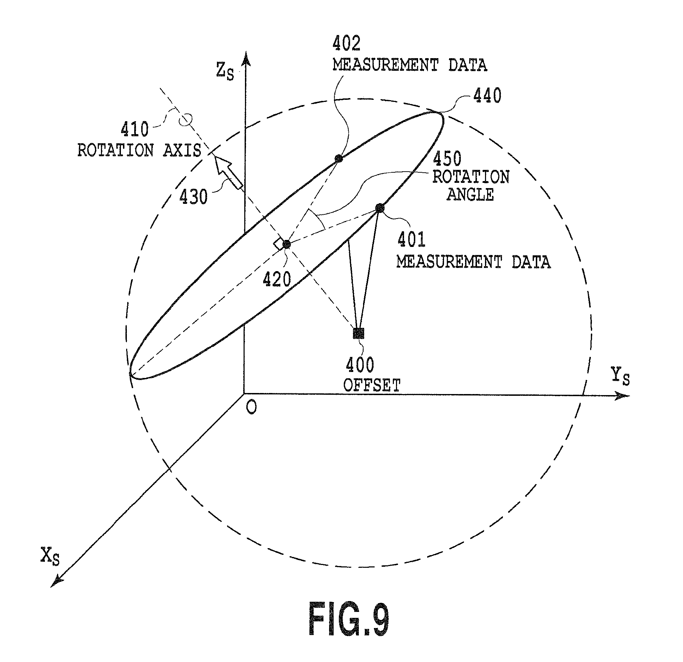

Fig. 9 is a diagram schematically showing a relation among a distribution status of geomagnetic data, an offset value and rotation axis information when time has elapsed in an environment that the magnitude of geomagnetic field is constant in a condition of the second exemplary embodiment. Fig. 9 is mainly different from Fig. 4 in that a rotation angle 450 is represented therein.

Firstly, with reference to Fig. 9, explanation will be made for a method of obtaining the rotation angle 450 from angular velocity data.

It is possible to express correspondence between the measurement data measured at the clock time t (i.e., the magnetic data 401) and the measurement data measured at the clock time t+1 (i.e., the magnetic data 402) as follows.

When rotated about the rotation axis 410 by the rotation angle 450, the magnetic data 401 can be converted into the magnetic data 402. Where the angular velocity data is used as a displacement in a meantime between the clock time t and the clock time t+1 as explained in the first exemplary embodiment, the rotation angle 450 can be obtained with use of the differential DCM data ($R_{BA}$) 453.

Here, for instance, it is assumed that a vector $V_2$ is obtained when a vector $V_1 = (1, 1, 1)^T$ is rotated with use of the differential DCM data ($R_{BA}$) 453.

Based on the inner product and the outer product of the pre-rotation vector $V_1$ and the post-rotation vector $V_2$, an angle between the two vectors can be obtained. The angle herein obtained corresponds to the rotation angle 450.

Here, the vector $V_1$ is obtained as a unit vector. However, the vector $V_1$ is not necessarily a unit vector. As long as the rotation angle 450 can be obtained with a given method, such method does not negatively affect the advantageous effect of the present invention at all.

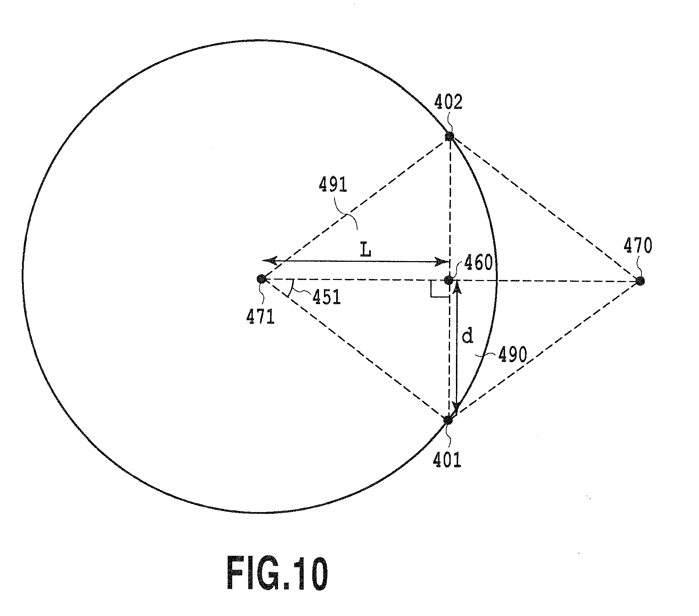

Fig. 10 is a diagram showing the circular plane 440 in Fig. 9 on a two-dimensional plane.

Based on the magnetic data 401 measured at the clock time t and the magnetic data 402 measured at the clock time t+1, a middle point 460 of the magnetic data 401 and the magnetic data 402 can be obtained.

Further, a spatial distance (d) 490 between the magnetic data 401 and the middle point 460 can be obtained using any of the combinations of (the magnetic data 401 and the magnetic data 402), (the magnetic data 401 and the middle point 460) and (the magnetic data 402 and the middle point 460).

An angle 451 will be half (1/2) the magnitude of the rotation angle 450 shown in Fig. 9. Therefore, a spatial distance 491 between the middle point 460 and the point 471 can be obtained with use of the angle 451 and the spatial distance 490. The spatial distance between the middle point 460 and a point 470 has the same value as the spatial distance (L) 491. Further, by obtaining the spatial distance between the middle point 460 and the point 470 with use of the angle 451, it is possible to obtain the spatial distance (L) 491 between the middle point 460 and the center 471 of the circular plane.

It should be noted that in the present exemplary embodiment, for instance, the method with use of the spatial distance (d) 490 and the angle 451 is employed as a method of obtaining the spatial distance (L) 491. However, the spatial distance (L) 491 may be configured to be obtained with use of another method.

The coordinate of the center 471 of the circular plane shown in Fig. 10 is located in a position away from the middle point 460 between the magnetic data 401 and the magnetic data 402 by the spatial distance (L) 491. As shown in Fig. 10, the two coordinates 470 and 471 exist as points located at an equal distance from the middle point 460. The coordinate value of the center 471 can be obtained from the middle point 460 and the spatial distance (L) 491. However, it is impossible to specify which of the coordinates 470 and 471 the coordinate of rotation center actually is.

In view of the above, two candidates for the rotation center coordinate are calculated by, for instance, performing a similar processing for a condition at the clock time t+2 when time has further elapsed from the clock time t+1.

Based on the positional relation among two candidates for the rotation center coordinate that are calculated with the combination of (the clock time t, clock time t+1) and two candidates for the rotation center coordinate that are calculated with the combination of (the clock time t+1, the clock time t+2), the rotation center coordinate is specified with use of the respective combinations. In short, there exist totally four combinations as the combinations of the rotation center coordinates. Among the combinations, the coordinate of the combination with the least spatial distance is estimated as the rotation center coordinate. Therefore, with use of the combinations of (the clock time t, the clock time t+1) and

(the clock time t+1, the clock time t+2), it is possible to estimate the rotation center coordinate where the respective conditions are used.

In the present exemplary embodiment, it is configured to calculate candidates for the rotation center coordinate and estimate the rotation center coordinate on the basis of the positional relation among the candidate coordinates. However, the rotation center coordinate may be specified with another method. Even with such method, the advantageous effect of the present invention is not negatively affected.

As to the rotation axis, when a coordinate on the rotation axis is obtained as described in the first exemplary embodiment, for instance, two coordinates on the rotation axis are supposed to be obtained including the aforementioned rotation center coordinate. Hence, a linear equation can be determined for the rotation axis.

The offset is estimated on the basis of thus obtained multiple rotation axes with use of the method as described in the first exemplary embodiment.

As described above, the second exemplary embodiment relates to explanation of an offset estimation device that estimates an offset of magnetic data to be outputted from a tri-axis geomagnetic detection part and is characterized in comprising:

a first rotation axis calculation part being configured to obtain magnetic data at a first clock time and magnetic data at a second clock time, both of which are outputted from the geomagnetic detection part, and rotation amount data being set as data in accordance with a rotation amount of the geomagnetic detection part in a time period corresponding to a meantime between the first clock time and the second clock time, the first rotation axis calculation part being configured to, in a coordinate space containing respective axial components of the magnetic data to be outputted from the geomagnetic detection part as coordinate values, calculate a first rotation axis in transition from a coordinate value based on the magnetic data at the first clock time to a coordinate value based on the magnetic data at the second clock time on the basis of the magnetic data at the first clock time, the magnetic data at the second clock time and the rotation amount data in the time period corresponding to the meantime between the first clock time and the second clock time;

a second rotation axis calculation part being configured to obtain magnetic data at a third clock time and magnetic data at a fourth clock time, both of which are outputted from the geomagnetic detection part, and rotation amount data being set as data in accordance with a rotation amount of the geomagnetic detection part in a time period corresponding to a meantime between the third clock time and the fourth clock time, the second rotation axis calculation part being configured to, in the coordinate space containing the respective axial components of the magnetic data to be outputted from the geomagnetic detection part as coordinate values, calculate a second rotation axis in transition from a coordinate value based on the magnetic data at the third clock time to a coordinate value based on the magnetic data at the fourth clock time on the basis of the magnetic data at the third clock time, the magnetic data at the fourth clock time and the rotation amount data in the time period corresponding to the meantime between the third clock time and the fourth clock time; and

an offset estimation part being configured to estimate the offset of the magnetic data of the geomagnetic detection part on the basis of a coordinate value with minimum spatial distances to the first rotation axis and the second rotation axis.

When described in more detail, the second exemplary embodiment relates to explanation of the offset estimation device that the first rotation axis calculation part is configured to:

calculate at least two or more coordinate values on the first rotation axis on the basis of:

the magnetic data at the first clock time, the magnetic data at the second clock time and magnetic data at a fifth clock time;
the rotation amount data being set as the data in accordance with the rotation amount of the geomagnetic detection part in the time period corresponding to the meantime between the first clock time and the second clock time; and rotation amount data being set as data in accordance with a rotation amount of the geomagnetic detection part in a time period corresponding to a meantime between the second clock time and the fifth clock time, and
calculate the first rotation axis on the basis of the at least two or more coordinate values on the first rotation axis.

When described in more detail, the second exemplary embodiment relates to explanation of the offset estimation device that the second rotation axis calculation part is configured to:

calculate at least two or more coordinate values on the second rotation axis on the basis of:

the magnetic data at the third clock time, the magnetic data at the fourth clock time and magnetic data at a sixth clock time;

the rotation amount data being set as the data in accordance with the rotation amount of the geomagnetic detection part in the time period corresponding to the meantime between the third clock time and the fourth clock time; and rotation amount data being set as data in accordance with a rotation amount of the geomagnetic detection part in a time period corresponding to a meantime between the fourth clock time and the sixth clock time, and

calculate the second rotation axis on the basis of the at least two or more coordinate values on the second rotation axis.

It should be noted that in the offset estimation devices of the first and second exemplary embodiments, it is only required for estimation of the offset that the combination of the first clock time and the second clock time and that of the third clock time and the fourth clock time are not completely matched, and the offset may be estimated by setting the combination of the first clock time and the second clock time as (the clock time t, the clock time t+1) and setting the combination of the third clock time and the fourth clock time as (the clock time t, the clock time t+2).

With reference to the first and second exemplary embodiments, explanation has been made above for the offset estimation device and the offset estimation method, whereby the offset of the geomagnetic sensor can be accurately estimated. However, for instance, the functions of the offset estimation devices of the respective exemplary embodiments may be configured to be implemented by a program. In this case, an information device such as a portable terminal device or a computer can implement the functions of the aforementioned offset estimation device in accordance with the program.

Further, for instance, it is allowed to configure an information processing device such as a portable terminal device that includes the offset estimation device, the geomagnetic sensor (geomagnetic detection part) and the angular velocity sensor (angular velocity detection part) in each exemplary embodiment. Even with the configuration, the information processing device can achieve the advantageous effect explained in each exemplary embodiment.

Reference Signs List

| | |
|---|---|
| 10 | Physical amount measurement device |
| 20 | Magnetic sensor |
| 21 | Angular velocity sensor |
| 30 | Data obtainment unit |
| 40 | Offset estimation device |
| 41 | Sort part |
| 42 | DCM calculation part |
| 43 | Various angle calculation part |
| 44 | Data selection part |
| 45 | Rotational angle calculation part |
| 46 | Reference point calculation part |
| 47 | Reliability determination part |
| 48 | Parameter management part |
| 100 | Physical amount measurement system |
| 200 | Computation unit |

**Claims**

1. An offset estimation device for estimating an offset of magnetic data to be outputted from a tri-axis geomagnetic detection part, comprising:

a first rotation axis calculation part being configured to obtain magnetic data at a first clock time and magnetic data at a second clock time, both of which are outputted from the geomagnetic detection part, and first rotation amount data being set as data in accordance with a rotation amount of the geomagnetic detection part in a time period between the first clock time and the second clock time, the first rotation axis calculation part being configured to, in a coordinate space containing respective axial components of the magnetic data to be outputted from the geomagnetic detection part as coordinate values, calculate a first rotation axis in transition from a coordinate value based on the magnetic data at the first clock time to a coordinate value based on the magnetic data at the second clock time on the basis of the magnetic data at the first clock time, the magnetic data at the second clock time and the first rotation amount data in the time period between the first clock time and the second clock time;

a second rotation axis calculation part being configured to obtain magnetic data at a third clock time and magnetic data at a fourth clock time, both of which are outputted from the geomagnetic detection part, and second rotation amount data being set as data in accordance with a rotation amount of the geomagnetic detection part in a time period between the third clock time and the fourth clock time, the second rotation axis calculation part being configured to, in the coordinate space containing the respective axial components of the magnetic data to be outputted from the geomagnetic detection part as coordinate values, calculate a second rotation axis in transition from a coordinate value based on the magnetic data at the third clock time to a coordinate value based on the magnetic data at the fourth clock time on the basis of the magnetic data at the third clock time, the magnetic data at the fourth clock time and the second rotation amount data in the time period corresponding to the meantime between the third clock time and the fourth clock time; and

an offset estimation part being configured to estimate the offset of the magnetic data of the geomagnetic detection part on the basis of a coordinate value with minimum spatial distances to the first rotation axis and the second rotation axis.

2. The offset estimation device recited in claim 1, wherein the first rotation axis calculation part is configured to:

calculate a direction vector of the first rotation axis on the basis of the first rotation amount data being set as the data in accordance with the rotation amount of the geomagnetic detection part in the time period the first clock time and the second clock time;

calculate a coordinate value on the first rotation axis on the basis of the magnetic data at the first clock time, the magnetic data at the second clock time and the first rotation amount data being set as the data in accordance with the rotation amount of the geomagnetic detection part in the time period between the first clock time and the second clock time; and

calculate the first rotation axis on the basis of the direction vector of the first rotation axis and the coordinate value on the first rotation axis.

3. The offset estimation device recited in claim 1, wherein the first rotation axis calculation part is configured to:

calculate at least two or more coordinate values on the first rotation axis on the basis of:

the magnetic data at the first clock time, the magnetic data at the second clock time and magnetic data at a fifth clock time;

the first rotation amount data being set as the data in accordance with the rotation amount of the geomagnetic detection part in the time period between the first clock time and the second clock time; and

third rotation amount data being set as data in accordance with a rotation amount of the geomagnetic detection part in a time period between the second clock time and the fifth clock time, and

calculate the first rotation axis on the basis of the at least two or more coordinate values on the first rotation axis.

4. The offset estimation device recited in any one of claims 1 to 3, wherein the second rotation axis calculation part is configured to:

calculate a direction vector of the second rotation axis on the basis of the second rotation amount data being set as the data in accordance with the rotation amount of the geomagnetic detection part in the time period between the third clock time and the fourth clock time;

calculate a coordinate value on the second rotation axis on the basis of the magnetic data at the third clock time, the magnetic data at the fourth clock time and the second rotation amount data being set as the data in accordance with the rotation amount of the geomagnetic detection part in the time period between the third clock time and the fourth clock time; and

calculate the second rotation axis on the basis of the direction vector of the second rotation axis and the coordinate value on the second rotation axis.

5. The offset estimation device recited in any one of claims 1 to 3, wherein the second rotation axis calculation part is configured to:

calculate at least two or more coordinate values on the second rotation axis on the basis of:

the magnetic data at the third clock time, the magnetic data at the fourth clock time and magnetic data at a sixth clock time;
the second rotation amount data being set as the data in accordance with the rotation amount of the geomagnetic detection part in the time period between the third clock time and the fourth clock time; and fourth rotation amount data being set as data in accordance with a rotation amount of the geomagnetic detection part in a time period between the fourth clock time and the sixth clock time, and
calculate the second rotation axis on the basis of the at least two or more coordinate values on the second rotation axis.

6. The offset estimation device recited in claim 4 or 5, wherein
the first rotation axis calculation part is configured to:

calculate a first direction cosine matrix corresponding to the first clock time on the basis of a direction cosine matrix corresponding to a clock time preceding the first clock time and fifth rotation amount data of the geomagnetic detection part in a time period between the clock time preceding the first clock time and the first clock time;
calculate a second direction cosine matrix corresponding to the second clock time on the basis of the direction cosine matrix corresponding to the clock time preceding the first clock time and sixth rotation amount data of the geomagnetic detection part in a time period between the clock time preceding the first clock time and the second clock time;
calculate a first differential direction cosine matrix in accordance with the rotation amount of the geomagnetic detection part in the time period between the first clock time and the second clock time; and
calculate the coordinate value on the first rotation axis on the basis of the first differential direction cosine matrix, a transpose of the first differential direction cosine matrix, the magnetic data at the first clock time and the magnetic data at the second clock time, and

the second rotation axis calculation part is configured to:

calculate a third direction cosine matrix corresponding to the third clock time on the basis of the direction cosine matrix corresponding to the clock time preceding the first clock time and seventh rotation amount data of the geomagnetic detection part in a time period r between the clock time preceding the first clock time and the third clock time;
calculate a fourth direction cosine matrix corresponding to the fourth clock time on the basis of the direction cosine matrix corresponding to the clock time preceding the first clock time and eighth rotation amount data of the geomagnetic detection part in a time period r between the clock time preceding the first clock time and the fourth clock time;
calculate a second differential direction cosine matrix in accordance with the second rotation amount of the geomagnetic detection part in the time period between the third clock time and the fourth clock time on the basis of the third direction cosine matrix and the fourth direction cosine matrix; and
calculate the coordinate value on the second rotation axis on the basis of the second differential direction cosine matrix, a transpose of the second differential direction cosine matrix, the magnetic data at the third clock time and the magnetic data at the fourth clock time.

7. The offset estimation device recited in claim 6, wherein the direction vector of the first rotation axis is configured to be calculated on the basis of the first differential direction cosine matrix.

8. The offset estimation device recited in claim 6 or 7, wherein the direction vector of the second rotation axis is configured to be calculated on the basis of the second differential direction cosine matrix.

9. The offset estimation device recited in claim 3, wherein the first rotation axis calculation part is configured to:

calculate a first direction cosine matrix corresponding to the first clock time on the basis of a direction cosine matrix corresponding to a clock time preceding the first clock time and fifth rotation amount data of the geomagnetic detection part in a time period between the clock time preceding the first clock time and the first clock time;
calculate a second direction cosine matrix corresponding to the second clock time on the basis of the direction cosine matrix corresponding to the clock time preceding the first clock time and sixth rotation amount data of the geomagnetic detection part in a time period between the clock time preceding the first clock time and the second clock time;

calculate a fifth direction cosine matrix corresponding to the fifth clock time on the basis of the direction cosine matrix corresponding to the clock time preceding the first clock time and ninth rotation amount data of the geomagnetic detection part in a time period between the clock time preceding the first clock time to the fifth clock time;

calculate a first differential cosine matrix in accordance with the first rotation amount of the geomagnetic detection part in the time period between the first clock time and the second clock time on the bases of the first direction cosine matrix and the second direction cosine matrix;

calculate a third differential direction cosine matrix in accordance with the third rotation amount of the geomagnetic detection part in the time period between the second clock time and the fifth clock time on the basis of the second direction cosine matrix and the fifth direction cosine matrix;

calculate a first rotation angle in accordance with the first rotation amount of the geomagnetic detection part in the time period between the first clock time and the second clock time on the basis of the first differential direction cosine matrix;

calculate a second rotation angle in accordance with the third rotation amount of the geomagnetic detection part in the time period between the second clock time and the fifth clock time on the basis of the third differential direction cosine matrix; and

calculate the coordinate values on the first rotation axis on the basis of the first rotation angle, the second rotation angle, the magnetic data at the first clock time, the magnetic data at the second clock time and the magnetic data at the fifth clock time.

10. The offset estimation device recited in claim 5, wherein the second rotation axis calculation part is configured to:

calculate a third direction cosine matrix corresponding to the third clock time on the basis of a direction cosine matrix corresponding to a clock time preceding the first clock time and rotation amount data of the geomagnetic detection part in a time period between the clock time preceding the first clock time and the third clock time;

calculate a fourth direction cosine matrix corresponding to the fourth clock time on the basis of the direction cosine matrix corresponding to the clock time preceding the first clock time and eighth rotation amount data of the geomagnetic detection part in a time period between the clock time preceding the first clock time and the fourth clock time;

calculate a sixth direction cosine matrix corresponding to the sixth clock time on the basis of the direction cosine matrix corresponding to the clock time preceding the first clock time and tenth rotation amount data of the geomagnetic detection part in a time period between the clock time preceding the first clock time and the sixth clock time;

calculate a second differential direction cosine matrix in accordance with the second rotation amount of the geomagnetic detection part in the time period between the third clock time and the fourth clock time on the basis of the third direction cosine matrix and the fourth direction cosine matrix;

calculate a fourth differential direction cosine matrix in accordance with the fourth rotation amount of the geomagnetic detection part in the time period between the fourth clock time and the sixth clock time on the basis of the fourth direction cosine matrix and the sixth direction cosine matrix;

calculate a third rotation angle in accordance with the second rotation amount of the geomagnetic detection part in the time period between the third clock time and the fourth clock time on the basis of the second differential direction cosine matrix;

calculate a fourth rotation angle in accordance with the fourth rotation amount of the geomagnetic detection part in the time period between the fourth clock time and the sixth clock time on the basis of the fourth differential direction cosine matrix; and

calculate the coordinate values on the second rotation axis on the basis of the third rotation angle, the fourth rotation angle, the magnetic data at the third clock time, the magnetic data at the fourth clock time and the magnetic data at the sixth clock time.

11. The offset estimation device recited in any one of claims 1 to 10, wherein the first to tenth rotation amount data is configured to be based on any of angular data, angular velocity data and angular acceleration data.

12. An offset estimation method, comprising:

a first rotation axis calculation step of : obtaining magnetic data at a first clock time and magnetic data at a second clock time, both of which are outputted from the geomagnetic detection part, and rotation amount data being set as data in accordance with a first rotation amount of the geomagnetic detection part in a time period between the first clock time and the second clock time; and in a coordinate space containing respective axial components of the magnetic data to be outputted from the geomagnetic detection part as coordinate values; calculating a first rotation axis in transition from a coordinate value based on the magnetic data at the first clock time to a coordinate value based on the magnetic data at the second clock time on the basis of the magnetic data at the first clock time, the magnetic data at the second clock time and the first rotation amount data in the time period between the first clock time and the second clock time;

a second rotation axis calculation step of: obtaining magnetic data at a third clock time and magnetic data at a fourth clock time, both of which are outputted from the geomagnetic detection part, and second rotation amount data being set as data in accordance with a rotation amount of the geomagnetic detection part in a time period a meantime between the third clock time and the fourth clock time; and in the coordinate space containing the respective axial components of the magnetic data to be outputted from the geomagnetic detection part as coordinate values; calculating a second rotation axis in transition from a coordinate value based on the magnetic data at the third clock time to a coordinate value based on the magnetic data at the fourth clock time on the basis of the magnetic data at the third clock time, the magnetic data at the fourth clock time and the second rotation amount data in the time period between the third clock time and the fourth clock time; and

an offset estimation step of estimating an offset of the magnetic data of the geomagnetic detection part on the basis of a coordinate value with minimum spatial distances to the first rotation axis and the second rotation axis.

13. An offset estimation program for causing a computer to estimate an offset of magnetic data to be outputted from a tri-axis geomagnetic detection part, wherein causing the computer to:

obtain magnetic data at a first clock time and magnetic data at a second clock time, both of which are outputted from the geomagnetic detection part, and first rotation amount data being set as data in accordance with a rotation amount of the geomagnetic detection part in a time period between the first clock time and the second clock time, and in a coordinate space containing respective axial components of the magnetic data to be outputted from the geomagnetic detection part as coordinate values, calculate a first rotation axis in transition from a coordinate value based on the magnetic data at the first clock time to a coordinate value based on the magnetic data at the second clock time on the basis of the magnetic data at the first clock time, the magnetic data at the second clock time and the first rotation amount data in the time period between the first clock time and the second clock time;

obtain magnetic data at a third clock time and magnetic data at a fourth clock time, both of which are outputted from the geomagnetic detection part, and second rotation amount data being set as data in accordance with a rotation amount of the geomagnetic detection part in a time period r between the third clock time and the fourth clock time, and in the coordinate space containing the respective axial components of the magnetic data to be outputted from the geomagnetic detection part as coordinate values, calculate a second rotation axis in transition from a coordinate value based on the magnetic data at the third clock time to a coordinate value based on the magnetic data at the fourth clock time on the basis of the magnetic data at the third clock time, the magnetic data at the fourth clock time and the second rotation amount data in the time period between the third clock time and the fourth clock time; and

estimate the offset of the magnetic data of the geomagnetic detection part on the basis of a coordinate value with minimum spatial distances to the first rotation axis and the second rotation axis.

14. An information processing device, comprising:

the offset estimation device recited in any one of claims 1 to 11;
a geomagnetic detection part; and
an angular velocity detection part.

**Patentansprüche**

1. Versatzschätzungsvorrichtung zum Schätzen eines Versatzes von Magnetdaten, die von einem dreiachsigen Teil zum Erfassen des Erdmagnetfelds ausgegeben werden, umfassend:

ein Teil zum Ermitteln einer ersten Rotationsachse, das dazu konfiguriert ist, Magnetdaten zu einem ersten Taktzeitpunkt und Magnetdaten zu einem zweiten Taktzeitpunkt, die beide von dem Teil zum Erfassen des Erdmagnetfelds ausgegeben werden, sowie Daten über einen ersten Rotationsumfang zu beschaffen, die als Daten in Übereinstimmung mit einem Rotationsumfang des Teils zum Erfassen des Erdmagnetfelds innerhalb eines Zeitraums zwischen dem ersten Taktzeitpunkt und dem zweiten Taktzeitpunkt angesetzt sind, wobei das Teil zum Ermitteln der ersten Rotationsachse in einem Koordinatenraum mit jeweils axialen Komponenten der Magnetdaten, die von dem Teil zum Erfassen des Erdmagnetfelds als Koordinatenwerte ausgegeben werden, zu Folgendem konfiguriert ist,

Ermitteln einer ersten Rotationsachse im Übergang von einem Koordinatenwert auf der Grundlage der Magnetdaten zum ersten Taktzeitpunkt zu einem Koordinatenwert auf der Grundlage der Magnetdaten zum zweiten Taktzeitpunkt auf der Grundlage der Magnetdaten zum ersten Taktzeitpunkt, der Magnetdaten zum zweiten Taktzeitpunkt und der Daten über den ersten Rotationsumfang im Zeitraum zwischen dem ersten Taktzeitpunkt und dem zweiten Taktzeitpunkt;

ein Teil zum Ermitteln einer zweiten Rotationsachse, das dazu konfiguriert ist, Magnetdaten zu einem dritten Taktzeitpunkt und Magnetdaten zu einem vierten Taktzeitpunkt, die beide von dem Teil zum Erfassen des Erdmagnetfelds ausgegeben werden, sowie Daten über einen zweiten Rotationsumfang zu beschaffen, die als Daten in Übereinstimmung mit einem Rotationsumfang des Teils zum Erfassen des Erdmagnetfelds innerhalb eines Zeitraums zwischen dem dritten Taktzeitpunkt und dem vierten Taktzeitpunkt angesetzt sind, wobei das Teil zum Ermitteln der zweiten Rotationsachse in dem Koordinatenraum mit den jeweils axialen Komponenten der Magnetdaten, die von dem Teil zum Erfassen des Erdmagnetfelds als Koordinatenwerte ausgegeben werden, zu Folgendem konfiguriert ist,

Ermitteln einer zweiten Rotationsachse im Übergang von einem Koordinatenwert auf der Grundlage der Magnetdaten zum dritten Taktzeitpunkt zu einem Koordinatenwert auf der Grundlage der Magnetdaten zum vierten Taktzeitpunkt auf der Grundlage der Magnetdaten zum dritten Taktzeitpunkt, der Magnetdaten zum vierten Taktzeitpunkt und der Daten über den zweiten Rotationsumfang im Zeitraum zwischen dem dritten Taktzeitpunkt und dem vierten Taktzeitpunkt; und

ein Teil zum Schätzen des Versatzes, das dazu konfiguriert ist, den Versatz der Magnetdaten des Teils zum Erfassen des Erdmagnetfelds auf der Grundlage eines Koordinatenwerts mit einem minimalen räumlichen Abstand zur ersten Rotationsachse und zur zweiten Rotationsachse zu schätzen.

2. Versatzschätzungsvorrichtung nach Anspruch 1, wobei das Teil zum Ermitteln der ersten Rotationsachse zu Folgendem konfiguriert ist:

Ermitteln eines Richtungsvektors der ersten Rotationsachse auf der Grundlage der Daten über den ersten Rotationsumfang, die als Daten in Übereinstimmung mit einem Rotationsumfang des Teils zum Erfassen des Erdmagnetfelds innerhalb eines Zeitraums zwischen dem ersten Taktzeitpunkt und dem zweiten Taktzeitpunkt angesetzt sind;

Ermitteln eines Koordinatenwerts auf der ersten Rotationsachse auf der Grundlage der Magnetdaten zum ersten Taktzeitpunkt, der Magnetdaten zum zweiten Taktzeitpunkt und der Daten über den ersten Rotationsumfang, die als Daten in Übereinstimmung mit einem Rotationsumfang des Teils zum Erfassen des Erdmagnetfelds innerhalb eines Zeitraums zwischen dem ersten Taktzeitpunkt und dem zweiten Taktzeitpunkt angesetzt sind; und

Ermitteln der ersten Rotationsachse auf der Grundlage des Richtungsvektors der ersten Rotationsachse und des Koordinatenwerts auf der ersten Rotationsache.

3. Versatzschätzungsvorrichtung nach Anspruch 1, wobei das Teil zum Ermitteln der ersten Rotationsachse zu Folgendem konfiguriert ist:

Ermitteln von mindestens zwei oder mehr Koordinatenwerten auf der ersten Rotationsachse auf der Grundlage: der Magnetdaten zum ersten Taktzeitpunkt, der Magnetdaten zum zweiten Taktzeitpunkt und der Magnetdaten zu einem fünften Taktzeitpunkt; wobei die Daten über den ersten Rotationsumfang, die als Daten in Übereinstimmung mit einem Rotationsumfang des Teils zum Erfassen des Erdmagnetfelds innerhalb eines Zeitraums zwischen dem ersten Taktzeitpunkt und dem zweiten Taktzeitpunkt angesetzt sind; und Daten über einen dritten Rotationsumfang, die als Daten in Übereinstimmung mit einem Rotationsumfang des Teils zum Erfassen des Erdmagnetfelds innerhalb eines Zeitraums zwischen dem zweiten Taktzeitpunkt und dem fünften Taktzeitpunkt angesetzt sind; und

Ermitteln der ersten Rotationsachse auf der Grundlage der mindestens zwei oder mehr Koordinatenwerte auf der ersten Rotationsache.

4. Versatzschätzungsvorrichtung nach einem der Ansprüche 1 bis 3, wobei das Teil zum Ermitteln der zweiten Rotationsachse zu Folgendem konfiguriert ist:

Ermitteln eines Richtungsvektors der zweiten Rotationsachse auf der Grundlage der Daten über den zweiten Rotationsumfang, die als Daten in Übereinstimmung mit einem Rotationsumfang des Teils zum Erfassen des Erdmagnetfelds innerhalb eines Zeitraums zwischen dem dritten Taktzeitpunkt und dem vierten Taktzeitpunkt angesetzt sind;
Ermitteln eines Koordinatenwerts auf der zweiten Rotationsachse auf der Grundlage der Magnetdaten zum dritten Taktzeitpunkt, der Magnetdaten zum vierten Taktzeitpunkt und der Daten über den zweiten Rotationsumfang, die als Daten in Übereinstimmung mit einem Rotationsumfang des Teils zum Erfassen des Erdmagnetfelds innerhalb eines Zeitraums zwischen dem dritten Taktzeitpunkt und dem vierten Taktzeitpunkt angesetzt sind; und
Ermitteln der zweiten Rotationsachse auf der Grundlage des Richtungsvektors der zweiten Rotationsachse und des Koordinatenwerts auf der zweiten Rotationsache.

5. Versatzschätzungsvorrichtung nach einem der Ansprüche 1 bis 3, wobei das Teil zum Ermitteln der zweiten Rotationsachse zu Folgendem konfiguriert ist:

Ermitteln von mindestens zwei oder mehr Koordinatenwerten auf der zweiten Rotationsachse auf der Grundlage: der Magnetdaten zum dritten Taktzeitpunkt, der Magnetdaten zum vierten Taktzeitpunkt und der Magnetdaten zu einem sechsten Taktzeitpunkt; wobei die Daten über den zweiten Rotationsumfang, die als Daten in Übereinstimmung mit einem Rotationsumfang des Teils zum Erfassen des Erdmagnetfelds innerhalb eines Zeitraums zwischen dem dritten Taktzeitpunkt und dem vierten Taktzeitpunkt angesetzt sind; und Daten über einen vierten Rotationsumfang, die als Daten in Übereinstimmung mit einem Rotationsumfang des Teils zum Erfassen des Erdmagnetfelds innerhalb eines Zeitraums zwischen dem vierten Taktzeitpunkt und dem sechsten Taktzeitpunkt angesetzt sind; und
Ermitteln der zweiten Rotationsachse auf der Grundlage der mindestens zwei oder mehr Koordinatenwerte auf der zweiten Rotationsache.

6. Versatzschätzungsvorrichtung nach Anspruch 4 oder 5, wobei
das Teil zum Ermitteln der ersten Rotationsachse zu Folgendem konfiguriert ist:

Ermitteln einer Cosinus-Matrix einer ersten Richtung, die dem ersten Taktzeitpunkt entspricht, auf der Grundlage der Cosinus-Matrix einer Richtung, die einem vor dem ersten Taktzeitpunkt liegenden Taktzeitpunkt entspricht, und Daten über den fünften Rotationsumfang des Teils zum Erfassen des Erdmagnetfelds innerhalb eines Zeitraums zwischen dem Taktzeitpunkt vor dem ersten Taktzeitpunkt und dem ersten Taktzeitpunkt;
Ermitteln einer Cosinus-Matrix einer zweiten Richtung, die dem zweiten Taktzeitpunkt entspricht, auf der Grundlage der Cosinus-Matrix einer Richtung, die dem vor dem ersten Taktzeitpunkt liegenden Taktzeitpunkt entspricht, und Daten über einen sechsten Rotationsumfang des Teils zum Erfassen des Erdmagnetfelds innerhalb eines Zeitraums zwischen dem Taktzeitpunkt vor dem ersten Taktzeitpunkt und dem zweiten Taktzeitpunkt;
Ermitteln einer Cosinus-Matrix einer ersten Differenzialrichtung in Übereinstimmung mit dem Rotationsumfang des Teils zum Erfassen des Erdmagnetfelds innerhalb des Zeitraums zwischen dem ersten Taktzeitpunkt und dem zweiten Taktzeitpunkt; und
Ermitteln des Koordinatenwerts auf der ersten Rotationsachse auf der Grundlage der Cosinus-Matrix der ersten Differenzialrichtung, einer Transponierten der Cosinus-Matrix der ersten Differenzialrichtung, der Magnetdaten zum ersten Taktzeitpunkt und der Magnetdaten zum zweiten Taktzeitpunkt, und
das Teil zum Ermitteln der weiten Rotationsachse zu Folgendem konfiguriert ist:

Ermitteln einer Cosinus-Matrix einer dritten Richtung, die dem dritten Taktzeitpunkt entspricht, auf der Grundlage der Cosinus-Matrix einer Richtung, die dem vor dem ersten Taktzeitpunkt liegenden Taktzeitpunkt entspricht, und Daten über einen siebten Rotationsumfang des Teils zum Erfassen des Erdmagnetfelds innerhalb eines Zeitraums zwischen dem Taktzeitpunkt vor dem ersten Taktzeitpunkt und dem dritten Taktzeitpunkt;
Ermitteln einer Cosinus-Matrix einer vierten Richtung, die dem vierten Taktzeitpunkt entspricht, auf der Grundlage der Cosinus-Matrix einer Richtung, die dem vor dem ersten Taktzeitpunkt liegenden Taktzeitpunkt entspricht, und Daten über einen achten Rotationsumfang des Teils zum Erfassen des Erdmagnetfelds innerhalb eines Zeitraums zwischen dem Taktzeitpunkt vor dem ersten Taktzeitpunkt und dem vierten Taktzeitpunkt;
Ermitteln einer Cosinus-Matrix einer zweiten Differenzialrichtung in Übereinstimmung mit dem zweiten Rotationsumfang des Teils zum Erfassen des Erdmagnetfelds innerhalb des Zeitraums zwischen dem dritten Taktzeitpunkt und dem vierten Taktzeitpunkt auf der Grundlage der Cosinus-Matrix der dritten Richtung und der Cosinus-Matrix der vierten Richtung; und

Ermitteln des Koordinatenwerts auf der zweiten Rotationsachse auf der Grundlage der Cosinus-Matrix der zweiten Differenzialrichtung, einer Transponierten der Cosinus-Matrix der zweiten Differenzialrichtung, der Magnetdaten zum dritten Taktzeitpunkt und der Magnetdaten zum vierten Taktzeitpunkt.

7.  Versatzschätzungsvorrichtung nach Anspruch 6, wobei der Richtungsvektor der ersten Rotationsachse dazu konfiguriert ist, auf der Grundlage der Cosinus-Matrix der ersten Differenzialrichtung ermittelt zu werden.

8.  Versatzschätzungsvorrichtung nach Anspruch 6 oder 7, wobei der Richtungsvektor der zweiten Rotationsachse dazu konfiguriert ist, auf der Grundlage der Cosinus-Matrix der zweiten Differenzialrichtung ermittelt zu werden.

9.  Versatzschätzungsvorrichtung nach Anspruch 3, wobei das Teil zum Ermitteln der ersten Rotationsachse zu Folgendem konfiguriert ist:

Ermitteln einer Cosinus-Matrix einer ersten Richtung, die dem ersten Taktzeitpunkt entspricht, auf der Grundlage der Cosinus-Matrix einer Richtung, die einem vor dem ersten Taktzeitpunkt liegenden Taktzeitpunkt entspricht, und Daten über den fünften Rotationsumfang des Teils zum Erfassen des Erdmagnetfelds innerhalb eines Zeitraums zwischen dem Taktzeitpunkt vor dem ersten Taktzeitpunkt und dem ersten Taktzeitpunkt;

Ermitteln einer Cosinus-Matrix einer zweiten Richtung, die dem zweiten Taktzeitpunkt entspricht, auf der Grundlage der Cosinus-Matrix einer Richtung, die dem vor dem ersten Taktzeitpunkt liegenden Taktzeitpunkt entspricht, und Daten über einen sechsten Rotationsumfang des Teils zum Erfassen des Erdmagnetfelds innerhalb eines Zeitraums zwischen dem Taktzeitpunkt vor dem ersten Taktzeitpunkt und dem zweiten Taktzeitpunkt;

Ermitteln einer Cosinus-Matrix einer fünften Richtung, die dem fünften Taktzeitpunkt entspricht, auf der Grundlage der Cosinus-Matrix einer Richtung, die dem vor dem ersten Taktzeitpunkt liegenden Taktzeitpunkt entspricht, und Daten über einen neunten Rotationsumfang des Teils zum Erfassen des Erdmagnetfelds innerhalb eines Zeitraums zwischen dem Taktzeitpunkt vor dem ersten Taktzeitpunkt und dem fünften Taktzeitpunkt;

Ermitteln einer Cosinus-Matrix eines ersten Differenzials in Übereinstimmung mit dem ersten Rotationsumfang des Teils zum Erfassen des Erdmagnetfelds innerhalb des Zeitraums zwischen dem ersten Taktzeitpunkt und dem zweiten Taktzeitpunkt auf der Grundlage der Cosinus-Matrix der ersten Richtung und der Cosinus-Matrix der zweiten Richtung; und

Ermitteln einer Cosinus-Matrix einer dritten Differenzialrichtung in Übereinstimmung mit dem dritten Rotationsumfang des Teils zum Erfassen des Erdmagnetfelds innerhalb des Zeitraums zwischen dem zweiten Taktzeitpunkt und dem fünften Taktzeitpunkt auf der Grundlage der Cosinus-Matrix der zweiten Richtung und der Cosinus-Matrix der fünften Richtung;

Ermitteln eines ersten Rotationswinkels in Übereinstimmung mit dem ersten Rotationsumfang des Teils zum Erfassen des Erdmagnetfelds innerhalb des Zeitraums zwischen dem ersten Taktzeitpunkt und dem zweiten Taktzeitpunkt auf der Grundlage der Cosinus-Matrix der ersten Differenzialrichtung; und

Ermitteln eines zweiten Rotationswinkels in Übereinstimmung mit dem dritten Rotationsumfang des Teils zum Erfassen des Erdmagnetfelds innerhalb des Zeitraums zwischen dem zweiten Taktzeitpunkt und dem fünften Taktzeitpunkt auf der Grundlage der Cosinus-Matrix der dritten Differenzialrichtung; und

Ermitteln der Koordinatenwerte auf der ersten Rotationsachse auf der Grundlage des ersten Rotationswinkels, des zweiten Rotationswinkels, der Magnetdaten zum ersten Taktzeitpunkt, der Magnetdaten zum zweiten Taktzeitpunkt und der Magnetdaten zum fünften Taktzeitpunkt.

10. Versatzschätzungsvorrichtung nach Anspruch 5, wobei das Teil zum Ermitteln der zweiten Rotationsachse zu Folgendem konfiguriert ist:

Ermitteln einer Cosinus-Matrix einer dritten Richtung, die dem dritten Taktzeitpunkt entspricht, auf der Grundlage einer Cosinus-Matrix einer Richtung, die einem vor dem ersten Taktzeitpunkt liegenden Taktzeitpunkt entspricht, und Daten über einen Rotationsumfang des Teils zum Erfassen des Erdmagnetfelds innerhalb eines Zeitraums zwischen dem Taktzeitpunkt vor dem ersten Taktzeitpunkt und dem dritten Taktzeitpunkt;

Ermitteln einer Cosinus-Matrix einer vierten Richtung, die dem vierten Taktzeitpunkt entspricht, auf der Grundlage der Cosinus-Matrix einer Richtung, die dem vor dem ersten Taktzeitpunkt liegenden Taktzeitpunkt entspricht, und Daten über einen achten Rotationsumfang des Teils zum Erfassen des Erdmagnetfelds innerhalb eines Zeitraums zwischen dem Taktzeitpunkt vor dem ersten Taktzeitpunkt und dem vierten Taktzeitpunkt;

Ermitteln einer Cosinus-Matrix einer sechsten Richtung, die dem sechsten Taktzeitpunkt entspricht, auf der Grundlage der Cosinus-Matrix einer Richtung, die dem vor dem ersten Taktzeitpunkt liegenden Taktzeitpunkt entspricht, und Daten über einen zehnten Rotationsumfang des Teils zum Erfassen des Erdmagnetfelds innerhalb eines Zeitraums zwischen dem Taktzeitpunkt vor dem ersten Taktzeitpunkt und dem sechsten Taktzeitpunkt;

Ermitteln einer Cosinus-Matrix einer zweiten Differenzialrichtung in Übereinstimmung mit dem zweiten Rotationsumfang des Teils zum Erfassen des Erdmagnetfelds innerhalb des Zeitraums zwischen dem dritten Taktzeitpunkt und dem vierten Taktzeitpunkt auf der Grundlage der Cosinus-Matrix der dritten Richtung und der Cosinus-Matrix der vierten Richtung;

Ermitteln einer Cosinus-Matrix einer vierten Differenzialrichtung in Übereinstimmung mit dem vierten Rotationsumfang des Teils zum Erfassen des Erdmagnetfelds innerhalb des Zeitraums zwischen dem vierten Taktzeitpunkt und dem sechsten Taktzeitpunkt auf der Grundlage der Cosinus-Matrix der vierten Richtung und der Cosinus-Matrix der sechsten Richtung;

Ermitteln eines dritten Rotationswinkels in Übereinstimmung mit dem zweiten Rotationsumfang des Teils zum Erfassen des Erdmagnetfelds innerhalb des Zeitraums zwischen dem dritten Taktzeitpunkt und dem vierten Taktzeitpunkt auf der Grundlage der Cosinus-Matrix der zweiten Differenzialrichtung;

Ermitteln eines vierten Rotationswinkels in Übereinstimmung mit dem vierten Rotationsumfang des Teils zum Erfassen des Erdmagnetfelds innerhalb des Zeitraums zwischen dem vierten Taktzeitpunkt und dem sechsten Taktzeitpunkt auf der Grundlage der Cosinus-Matrix der vierten Differenzialrichtung; und

Ermitteln der Koordinatenwerte auf der zweiten Rotationsachse auf der Grundlage des dritten Rotationswinkels, des vierten Rotationswinkels, der Magnetdaten zum dritten Taktzeitpunkt, der Magnetdaten zum vierten Taktzeitpunkt und der Magnetdaten zum sechsten Taktzeitpunkt.

11. Versatzschätzungsvorrichtung nach einem der Ansprüche 1 bis 10, wobei die Daten über den ersten bis zehnten Rotationsumfang dazu konfiguriert sind, auf beliebigen Winkeldaten, Winkelgeschwindigkeitsdaten und Winkelbeschleunigungsdaten zu basieren.

12. Versatzschätzungsverfahren, umfassend

einen Schritt zum Ermitteln einer ersten Rotationsachse, umfassend: Beschaffen von Magnetdaten zu einem ersten Taktzeitpunkt und Magnetdaten zu einem zweiten Taktzeitpunkt, die beide von dem Teil zum Erfassen des Erdmagnetfelds ausgegeben werden, sowie von Daten über einen ersten Rotationsumfang, die als Daten in Übereinstimmung mit einem ersten Rotationsumfang des Teils zum Erfassen des Erdmagnetfelds innerhalb eines Zeitraums zwischen dem ersten Taktzeitpunkt und dem zweiten Taktzeitpunkt angesetzt sind, und in einem Koordinatenraum mit jeweils axialen Komponenten der Magnetdaten, die von dem Teil zum Erfassen des Erdmagnetfelds als Koordinatenwerte ausgegeben werden, Folgendes:

Ermitteln einer ersten Rotationsachse im Übergang von einem Koordinatenwert auf der Grundlage der Magnetdaten zum ersten Taktzeitpunkt zu einem Koordinatenwert auf der Grundlage der Magnetdaten zum zweiten Taktzeitpunkt auf der Grundlage der Magnetdaten zum ersten Taktzeitpunkt, der Magnetdaten zum zweiten Taktzeitpunkt und der Daten über den ersten Rotationsumfang im Zeitraum zwischen dem ersten Taktzeitpunkt und dem zweiten Taktzeitpunkt;

einen Schritt zum Ermitteln einer zweiten Rotationsachse, umfassend: Beschaffen von Magnetdaten zu einem dritten Taktzeitpunkt und Magnetdaten zu einem vierten Taktzeitpunkt, die beide von dem Teil zum Erfassen des Erdmagnetfelds ausgegeben werden, sowie von Daten über einen zweiten Rotationsumfang, die als Daten in Übereinstimmung mit einem Rotationsumfang des Teils zum Erfassen des Erdmagnetfelds innerhalb eines Zeitraums zwischen dem dritten Taktzeitpunkt und dem vierten Taktzeitpunkt angesetzt sind, und in dem Koordinatenraum mit jeweils axialen Komponenten der Magnetdaten, die von dem Teil zum Erfassen des Erdmagnetfelds als Koordinatenwerte ausgegeben werden, Folgendes:

Ermitteln einer zweiten Rotationsachse im Übergang von einem Koordinatenwert auf der Grundlage der Magnetdaten zum dritten Taktzeitpunkt zu einem Koordinatenwert auf der Grundlage der Magnetdaten zum vierten Taktzeitpunkt auf der Grundlage der Magnetdaten zum dritten Taktzeitpunkt, der Magnetdaten zum vierten Taktzeitpunkt und der Daten über den zweiten Rotationsumfang im Zeitraum zwischen dem dritten Taktzeitpunkt und dem vierten Taktzeitpunkt;

einen Versatzschätzschritt zum Schätzen eines Versatzes der Magnetdaten des Teils zum Erfassen des Erdmagnetfelds auf der Grundlage eines Koordinatenwerts mit einem minimalen räumlichen Abstand zur ersten Rotationsachse und zur zweiten Rotationsachse.

13. Versatzschätzungsprogramm, das in einem Computer das Schätzen eines Versatzes von Magnetdaten, die von einem dreiachsigen Teil zum Erfassen des Erdmagnetfelds ausgegeben werden, auslöst, wobei im Computer Folgendes ausgelöst wird:

Beschaffen von Magnetdaten zu einem ersten Taktzeitpunkt und Magnetdaten zu einem zweiten Taktzeitpunkt, die beide von dem Teil zum Erfassen des Erdmagnetfelds ausgegeben werden, sowie Daten über einen ersten Rotationsumfang, die als Daten in Übereinstimmung mit einem Rotationsumfang des Teils zum Erfassen des Erdmagnetfelds innerhalb eines Zeitraums zwischen dem ersten Taktzeitpunkt und dem zweiten Taktzeitpunkt angesetzt sind, und in einem Koordinatenraum mit den jeweils axialen Komponenten der Magnetdaten, die von dem Teil zum Erfassen des Erdmagnetfelds als Koordinatenwerte ausgegeben werden, Ermitteln einer ersten Rotationsachse im Übergang von einem Koordinatenwert auf der Grundlage der Magnetdaten zum ersten Taktzeitpunkt zu einem Koordinatenwert auf der Grundlage der Magnetdaten zum zweiten Taktzeitpunkt auf der Grundlage der Magnetdaten zum ersten Taktzeitpunkt, der Magnetdaten zum zweiten Taktzeitpunkt und der Daten über den ersten Rotationsumfang im Zeitraum zwischen dem ersten Taktzeitpunkt und dem zweiten Taktzeitpunkt;

Beschaffen von Magnetdaten zu einem dritten Taktzeitpunkt und Magnetdaten zu einem vierten Taktzeitpunkt, die beide von dem Teil zum Erfassen des Erdmagnetfelds ausgegeben werden, sowie von Daten über einen zweiten Rotationsumfang, die als Daten in Übereinstimmung mit einem Rotationsumfang des Teils zum Erfassen des Erdmagnetfelds innerhalb eines Zeitraums zwischen dem dritten Taktzeitpunkt und dem vierten Taktzeitpunkt angesetzt sind, und in dem Koordinatenraum mit jeweils axialen Komponenten der Magnetdaten, die von dem Teil zum Erfassen des Erdmagnetfelds als Koordinatenwerte ausgegeben werden, Folgendes:

Ermitteln einer zweiten Rotationsachse im Übergang von einem Koordinatenwert auf der Grundlage der Magnetdaten zum dritten Taktzeitpunkt zu einem Koordinatenwert auf der Grundlage der Magnetdaten zum vierten Taktzeitpunkt auf der Grundlage der Magnetdaten zum dritten Taktzeitpunkt, der Magnetdaten zum vierten Taktzeitpunkt und der Daten über den zweiten Rotationsumfang im Zeitraum zwischen dem dritten Taktzeitpunkt und dem vierten Taktzeitpunkt;

Schätzen des Versatzes der Magnetdaten des Teils zum Erfassen des Erdmagnetfelds auf der Grundlage eines Koordinatenwerts mit einem minimalen räumlichen Abstand zur ersten Rotationsachse und zur zweiten Rotationsachse.

**14.** Datenverarbeitungsvorrichtung, umfassend:

die Versatzschätzungsvorrichtung nach einem der Ansprüche 1 bis 11;
ein Teil zum Erfassen des Erdmagnetfelds; und
ein Teil zum Erfassen der Winkelgeschwindigkeit.

## Revendications

**1.** Dispositif d'estimation de décalage pour l'estimation d'un décalage de données magnétiques à délivrer en sortie par une partie de détection géomagnétique triaxiale, comprenant:

une partie de calcul de premier axe de rotation étant configurée pour obtenir des données magnétiques à une première heure et des données magnétiques à une deuxième heure, les deux étant délivrées par la partie de détection géomagnétique, et des premières données de quantité de rotation étant établies en tant que données selon une quantité de rotation de la partie de détection géomagnétique dans une période de temps comprise entre la première heure et la deuxième heure, la partie de calcul de premier axe de rotation étant configurée pour, dans une espace de coordonnées contenant des composantes axiales respectives des données magnétiques à délivrer en sortie par la partie de détection géomagnétique en tant que valeurs de coordonnées, calculer un premier axe de rotation en transition d'une valeur de coordonnée sur la base des données magnétiques à la première heure à une valeur de coordonnée sur la base des données magnétiques à la deuxième heure sur la base des données magnétiques à la première heure, des données magnétiques à la deuxième heure et des premières données de quantité de rotation dans la période de temps comprise entre la première heure et la deuxième heure ;

une partie de calcul de deuxième axe de rotation étant configurée pour obtenir des données magnétiques à une troisième heure et des données magnétiques à une quatrième heure, les deux étant délivrées en sortie par la partie de détection géomagnétique, et des secondes données de quantité de rotation étant établies en tant que données selon une quantité de rotation de la partie de détection géomagnétique, dans une période de temps comprise entre la troisième heure et la quatrième heure, la partie de calcul de deuxième axe de rotation étant configurée pour, dans l'espace de coordonnées contenant les composantes axiales respectives des données magnétiques à délivrer en sortie par la partie de détection géomagnétique en tant que valeurs de coordonnées, calculer un deuxième axe de rotation en transition d'une valeur de coordonnée sur la base des données magnétiques à la troisième heure à une valeur de coordonnées sur la base des données magnétiques à la troisième heure, des données magnétiques à la quatrième heure et des deuxièmes données de quantité de rotation dans la période de temps correspondant au temps moyen entre la troisième heure et la quatrième heure ; et

une partie d'estimation de décalage étant configurée pour estimer le décalage des données magnétiques de la partie de détection géomagnétique sur la base d'une valeur de coordonnée avec des distances spatiales minimales au premier axe de rotation et au deuxième axe de rotation.

2. Dispositif d'estimation de décalage selon la revendication 1, dans lequel la partie de calcul de premier axe de rotation est configurée pour :

   calculer un vecteur de direction du premier axe de rotation sur la base des premières données de quantité de rotation étant établies en tant que données selon la quantité de rotation de la partie de détection géomagnétique dans la période de temps comprise entre la première heure et la deuxième heure ;

   calculer une valeur de coordonnée sur le premier axe de rotation sur la base des données magnétiques à la première heure, des données magnétiques à la deuxième heure et des premières données de quantité de rotation étant établies en tant que données selon la quantité de rotation de la partie de détection géomagnétique dans la période de temps comprise entre la première heure et la deuxième heure ; et

   calculer le premier axe de rotation sur la base du vecteur de direction du premier axe de rotation et de la valeur de coordonnée sur le premier axe de rotation.

3. Dispositif d'estimation de décalage selon la revendication 1, dans lequel la partie de calcul de premier axe de rotation est configurée pour :

   calculer au moins deux valeurs de coordonnées ou plus sur le premier axe de rotation sur la base :

      des données magnétiques à la première heure, des données magnétiques à la deuxième heure et des données magnétiques à une cinquième heure ;

      des premières données de quantité de rotation étant établies en tant que données selon la quantité de rotation de la partie de détection géomagnétique dans la période de temps comprise entre la première heure et la deuxième heure ; et

      de troisièmes données de quantité de rotation étant établies en tant que données selon une quantité de rotation de la partie de détection géomagnétique dans une période de temps comprise entre la deuxième heure et la cinquième heure, et calculer le premier axe de rotation sur la base des au moins deux valeurs de coordonnées ou plus sur le premier axe de rotation.

4. Dispositif d'estimation de décalage selon l'une quelconque des revendications 1 à 3, dans lequel la partie de calcul de deuxième axe de rotation est configurée pour :

   calculer un vecteur de direction du deuxième axe de direction sur la base des deuxièmes données de quantité de rotation étant établies en tant que données selon la quantité de rotation de la partie de détection géomagnétique dans la période de temps comprise entre la troisième heure et la quatrième heure ;

   calculer une valeur de coordonnée sur le deuxième axe de rotation sur la base des données magnétiques à la troisième heure, des données magnétiques à la quatrième heure et des deuxièmes données de quantité de rotation étant établies en tant que données selon la quantité de rotation de la partie de détection géomagnétique dans la période de temps comprise entre la troisième heure et la quatrième heure ; et

   calculer le deuxième axe de rotation sur la base du vecteur de direction du deuxième axe de rotation et de la valeur de coordonnée sur le deuxième axe de rotation.

5. Dispositif d'estimation de décalage selon l'une quelconque des revendications 1 à 3, dans lequel la partie de calcul de deuxième axe de rotation est configurée pour :

   calculer au moins deux valeurs de coordonnées ou plus sur le deuxième axe de rotation sur la base :

      des données magnétiques à la troisième heure, des données magnétiques à la quatrième heure et des données magnétiques à une sixième heure ;

des deuxièmes données de quantité de rotation étant établies en tant que données selon la quantité de rotation de la partie de détection géomagnétique dans la période de temps comprise entre la troisième heure et la quatrième heure ; et

des quatrièmes données de quantité de rotation étant établies en tant que données selon une quantité de rotation de la partie de détection géomagnétique dans une période de temps comprise entre la quatrième heure et la sixième heure, et

calculer le deuxième axe de rotation sur la base des au moins deux valeurs de coordonnées ou plus sur le deuxième axe de rotation.

6. Dispositif d'estimation de décalage selon la revendication 4 ou 5, dans lequel la partie de calcul de premier axe de rotation est configurée pour :

calculer une première matrice de cosinus directeur correspondant à la première heure sur la base d'une matrice de cosinus directeur correspondant à une heure précédant la première heure et des cinquièmes données de quantité de rotation de la partie de détection géomagnétique dans une période de temps comprise entre l'heure précédant la première heure et la première heure ;

calculer une deuxième matrice de cosinus directeur correspondant à la deuxième heure sur la base de la matrice de cosinus directeur correspondant à l'heure précédant la première heure et des sixièmes données de quantité de rotation de la partie de détection géomagnétique dans une période de temps comprise entre l'heure précédant la première heure et la deuxième heure ;

calculer une première matrice de cosinus directeur différentielle selon la quantité de rotation de la partie de détection géomagnétique dans la période de temps comprise entre la première heure et la deuxième heure ; et

calculer la valeur de coordonnée sur le premier axe de rotation sur la base de la première matrice de cosinus directeur différentielle, d'une transposée de la première matrice de cosinus directeur différentielle, des données magnétiques à la première heure et des données magnétiques à la deuxième heure, et

la partie de calcul de deuxième axe de rotation est configurée pour :

calculer une troisième matrice de cosinus directeur correspondant à la troisième heure sur la base de la matrice de cosinus directeur correspondant à l'heure précédant la première heure et des septièmes données de quantité de rotation de la partie de détection géomagnétique dans une période de temps comprise entre l'heure précédant la première heure et la troisième heure ;

calculer une quatrième matrice de cosinus directeur correspondant à la quatrième heure sur la base de la matrice de cosinus directeur correspondant à l'heure précédant la première heure et des huitièmes données de quantité de rotation de la partie de détection géomagnétique dans une période de temps comprise entre l'heure précédant la première heure et la quatrième heure ;

calculer une deuxième matrice de cosinus directeur différentielle selon la deuxième quantité de rotation de la partie de détection géomagnétique dans la période de temps comprise entre la troisième heure et la quatrième heure sur la base de la troisième matrice de cosinus directeur et de la quatrième matrice de cosinus directeur; et

calculer la valeur de coordonnée sur le deuxième axe de rotation sur la base de la deuxième matrice de cosinus directeur différentielle, d'une transposée de la deuxième matrice de cosinus directeur différentielle, des données magnétiques à la troisième heure et des données magnétiques à la quatrième heure.

7. Dispositif d'estimation de décalage selon la revendication 6, dans lequel le vecteur de direction du premier axe de rotation est configuré pour être calculé sur la base de la première matrice de cosinus directeur différentielle.

8. Dispositif d'estimation de décalage selon la revendication 6 ou 7, dans lequel le vecteur de direction du deuxième axe de rotation est configuré pour être calculé sur la base de la deuxième matrice de cosinus directeur différentielle.

9. Dispositif d'estimation de décalage selon la revendication 3, dans lequel la partie de calcul de premier axe de rotation est configurée pour :

calculer une première matrice de cosinus directeur correspondant à la première heure sur la base d'une matrice de cosinus directeur correspondant à une heure précédant la première heure et des cinquièmes données de quantité de rotation de la partie de détection géomagnétique dans une période de temps comprise entre l'heure précédant la première heure et la première heure;

calculer une deuxième matrice de cosinus directeur correspondant à la deuxième heure sur la base de la matrice de cosinus directeur correspondant à l'heure précédant la première heure et des sixièmes données de quantité de rotation de la partie de détection géomagnétique dans une période de temps comprise entre l'heure précédant la première heure et la deuxième heure ;

calculer une cinquième matrice de cosinus directeur correspondant à la cinquième heure sur la base de la matrice de cosinus directeur correspondant à l'heure précédant la première heure et des neuvièmes données de quantité de rotation de la partie de détection géomagnétique dans une période de temps comprise entre l'heure précédant la première heure et la cinquième heure ;

calculer une première matrice de cosinus directeur différentielle selon la première quantité de rotation de la partie de détection géomagnétique dans la période de temps comprise entre la première heure et la deuxième heure sur la base de la première matrice de cosinus directeur et de la deuxième matrice de cosinus directeur ;

calculer une troisième matrice de cosinus directeur différentielle selon la troisième quantité de rotation de la partie de détection géomagnétique dans la période de temps comprise entre la deuxième heure et la cinquième heure sur la base de la deuxième matrice de cosinus directeur et de la cinquième matrice de cosinus directeur;

calculer un premier angle de rotation selon la première quantité de rotation de la partie de détection géomagnétique dans la période de temps comprise entre la première heure et la deuxième heure sur la base de la première matrice de cosinus directeur différentielle ;

calculer un deuxième angle de rotation selon la troisième quantité de rotation de la partie de détection géomagnétique dans la période de temps comprise entre la deuxième heure et la cinquième heure sur la base de la troisième matrice de cosinus directeur différentielle ; et

calculer les valeurs de coordonnées du premier axe de rotation sur la base du premier angle de rotation, du deuxième angle de rotation, des données magnétiques à la première heure, des données magnétiques à la deuxième heure et des données magnétiques à la cinquième heure.

**10.** Dispositif d'estimation de décalage selon la revendication 5, dans lequel la partie de calcul de deuxième axe de rotation est configurée pour :

calculer une troisième matrice de cosinus directeur correspondant à la troisième heure sur la base d'une matrice de cosinus directeur correspondant à une heure précédant la première heure et des données de quantité de rotation de la partie de détection géomagnétique dans une période de temps comprise entre l'heure précédant la première heure et la troisième heure ;

calculer une quatrième matrice de cosinus directeur correspondant à la quatrième heure sur la base de la matrice de cosinus directeur correspondant à l'heure précédant la première heure et des huitièmes données de quantité de rotation de la partie de détection géomagnétique dans une période de temps comprise entre l'heure précédant la première heure et la quatrième heure ;

calculer une sixième matrice de cosinus directeur correspondant à la sixième heure sur la base de la matrice de cosinus directeur correspondant à l'heure précédant la première heure et des dixièmes données de quantité de rotation de la partie de détection géomagnétique dans une période de temps comprise entre l'heure précédant la première heure et la sixième heure ;

calculer une deuxième matrice de cosinus directeur différentielle selon la deuxième quantité de rotation de la partie de détection géomagnétique dans la période de temps comprise entre la troisième heure et la quatrième heure sur la base de la troisième matrice de cosinus directeur et de la quatrième matrice de cosinus directeur;

calculer une quatrième matrice de cosinus directeur différentielle selon la quatrième quantité de rotation de la partie de détection géomagnétique dans la période de temps comprise entre la quatrième heure et la sixième heure sur la base de la quatrième matrice de cosinus directeur et de la sixième matrice de cosinus directeur;

calculer un troisième angle de rotation selon la deuxième quantité de rotation de la partie de détection géomagnétique dans la période de temps comprise entre la troisième heure et la quatrième heure sur la base de la deuxième matrice de cosinus directeur différentielle ;

calculer un quatrième angle de rotation selon la quatrième quantité de rotation de la partie de détection géomagnétique dans la période de temps comprise entre la quatrième heure et la sixième heure sur la base de la quatrième matrice de cosinus directeur différentielle ; et

calculer les valeurs de coordonnées sur le deuxième axe de rotation sur la base du troisième angle de rotation, du quatrième angle de rotation, des données magnétiques à la troisième heure, des données magnétiques à la quatrième heure et des données magnétiques à la sixième heure.

**11.** Dispositif d'estimation de décalage selon l'une quelconque des revendications 1 à 10, dans lequel les premières à dixièmes données de quantité de rotation sont configurées pour être sur la base de l'une quelconque de données angulaires, de données de vitesse angulaire et de données d'accélération angulaire.

**12.** Procédé d'estimation de décalage, comprenant :

une étape de calcul de premier axe de rotation visant à : obtenir des données magnétiques à une première heure et des données magnétiques à une deuxième heure, les deux étant délivrées en sortie par la partie de détection géomagnétique, et des données de quantité de rotation établies en tant que données selon une première quantité de rotation de la partie de détection géomagnétique dans une période de temps comprise entre la première heure et la deuxième heure ; et dans un espace de coordonnées contenant des composantes axiales respectives des données magnétiques à délivrer en sortie par la partie de détection géomagnétique sous la forme de valeurs de coordonnées ;

calculer un premier axe de rotation en transition d'une valeur de coordonnée sur la base des données magnétiques à la première heure à une valeur de coordonnée sur la base des données magnétiques à la deuxième heure sur la base des données magnétiques à la première heure, des données magnétiques à la deuxième heure et des premières données de quantité de rotation dans la période de temps comprise entre la première heure et la deuxième heure ;

une étape de calcul de deuxième axe de rotation visant à : obtenir des données magnétiques à une troisième heure et des données magnétiques à une quatrième heure, les deux étant délivrées en sortie par la partie de détection géomagnétique, et des deuxièmes données de quantité de rotation qui sont établies en tant que données selon une quantité de rotation de la partie de détection géomagnétique dans une période de temps qui est un temps moyen entre la troisième heure et la quatrième heure ; et dans l'espace de coordonnées contenant les composantes axiales respectives des données magnétiques à délivrer en sortie par la partie de détection géomagnétique sous la forme de valeurs de coordonnées;

calcul un deuxième axe de rotation en transition d'une valeur de coordonnée sur la base des données magnétiques à la troisième heure à une valeur de coordonnée sur la base des données magnétiques à la quatrième heure sur la base des données magnétiques à la troisième heure, des données magnétiques à la quatrième heure et des deuxièmes données de quantité de rotation dans la période de temps comprise entre la troisième heure et la quatrième heure ; et

une étape d'estimation de décalage pour l'estimation d'un décalage des données magnétiques de la partie de détection géomagnétique sur la base d'une valeur de coordonnée avec des distances spatiales minimales par rapport au premier axe de rotation et au deuxième axe de rotation.

**13.** Programme d'estimation de décalage pour amener un ordinateur à estimer un décalage de données magnétiques à délivrer en sortie par une partie de détection géomagnétique triaxiale, dans lequel l'ordinateur est amené à :

obtenir des données magnétiques à une première heure et des données magnétiques à une deuxième heure, les deux étant délivrées en sortie par la partie de détection géomagnétique, et des premières données de quantité de rotation qui sont établies en tant que données selon une quantité de rotation de la partie de détection géomagnétique dans une période de temps comprise entre la première heure et la deuxième heure, et dans une espace de coordonnées contenant des composantes axiales respectives des données magnétiques à délivrer en sortie par la partie de détection géomagnétique sous forme de valeurs de coordonnées, calculer un premier axe de rotation en transition d'une valeur de coordonnée sur la base des données magnétiques à la première heure à une valeur de coordonnée sur la base des données magnétiques à la deuxième heure sur la base des données magnétiques à la première heure, des données magnétiques à la deuxième heure et des premières données de quantité de rotation dans la période de temps comprise entre la première heure et la deuxième heure ;

obtenir des données magnétiques à une troisième heure et des données magnétiques à une quatrième heure, les deux étant délivrées en sortie par la partie de détection géomagnétique, et des deuxièmes données de quantité de rotation qui sont établies en tant que données selon la quantité de rotation de la partie de détection géomagnétique dans une période de temps comprise entre la troisième heure et la quatrième heure, et dans l'espace de coordonnées contenant les composantes axiales respectives des données magnétiques à délivrer en sortie par la partie de détection géomagnétique sous forme de valeurs de coordonnées, calculer un deuxième axe de rotation en transition d'une valeur de coordonnée sur la base des données magnétique à la troisième heure à une valeur de coordonnée sur la base des données magnétiques à la quatrième heure sur la base des données magnétiques à la troisième heure, des données magnétiques à la quatrième heure et des deuxièmes données de quantité de rotation dans la période de temps comprise entre la troisième heure et la quatrième heure ; et

estimer le décalage des données magnétiques de la partie de détection géomagnétique sur la base d'une valeur de coordonnée avec des distances spatiales minimales vis-à-vis du premier axe de rotation et du deuxième axe de rotation.

**14.** Dispositif de traitement d'informations, comprenant :

le dispositif d'estimation de décalage selon l'une quelconque des revendications 1 à 11;
une partie de détection géomagnétique ; et
une partie de détection de vitesse angulaire.

<u>100</u>

<u>10</u>

FIG.1

EP 2 818 828 B1

<u>40</u>

```
┌─────────────┐ 41
│  SORT PART  │
└─────────────┘
       │ DI
       ▼
┌─────────────┐ 42
│    DCM      │
│ CALCULATION │
│   PART      │
└─────────────┘
       │ RI
       ▼
┌─────────────┐ 43
│VARIOUS ANGLE│
│ CALCULATION │
│   PART      │
└─────────────┘
       │ AI
```

```
                                    ┌──────────────┐ 48
                                    │  PARAMETER   │
                                    │ MANAGEMENT   │
                                    │    PART      │
                                    └──────────────┘
```

```
┌──────────┐ 44  DI  ┌──────────┐ 45      ┌──────────┐ 46      ┌──────────┐ 47
│   DATA   │  RI     │ ROTATION │         │REFERENCE │         │RELIABILITY│
│SELECTION │  AI     │   AXIS   │  RLI    │  POINT   │   OI    │DETERMINATION│  OFFSET
│  PART    │────────►│CALCULATION│───────►│ESTIMATION│────────►│   PART    │────────►
└──────────┘         │   PART   │         │  PART    │         └──────────┘
                     └──────────┘         └──────────┘
```

DI: MEASUREMENT DATA GROUP
RI: DCM DATA GROUP
AI: DATA GROUP OF YAW ANGLE, ROLL ANGLE AND PITCH ANGLE
RLI: ROTATION AXIS INFORMATION GROUP
OI: ESTIMATED OFFSET GROUP

# FIG.2

FIG.3

FIG.4

FIG.5

**FIG.6**

410
$L_1$

411
$L_2$

400

# FIG.7

FIG.8

FIG.9

FIG.10

EP 2 818 828 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004309227 A